# EUROPEAN PATENT SPECIFICATION

(11) **EP 4 420 168 B1**
(45) Date of publication and mention of the grant of the patent: **18.02.2026**
(21) Application number: 22942955.0
(22) Date of filing: 30.12.2022
(51) Int. Cl.: G01T 1/24

(54) **PHOTON-COUNTING DETECTORS FOR DETECTING RADIATION**
PHOTONENZÄHLENDE DETEKTOREN ZUR DETEKTION VON STRAHLUNG
DÉTECTEURS DE COMPTAGE DE PHOTONS POUR DÉTECTER LE RAYONNEMENT

(43) Date of publication of application: 28.08.2024
(73) Proprietor: Shanghai United Imaging Healthcare Co., Ltd., Shanghai 201807 (CN)
(72) Inventor: NIE, Zhen, Shanghai 201807 (CN)
(74) Representative: Wang, Bo
(86) International application number: PCT/CN2022/144298
(87) International publication number: WO 2024/138727

(56) References cited:
- CN-A- 1 155 955
- CN-A- 1 190 467
- US-A1- 2003 155 516
- US-A1- 2008 093 560
- US-A1- 2008 093 560
- US-A1- 2013 049 151
- US-A1- 2013 168 750
- US-A1- 2013 168 750
- US-A1- 2019 096 950
- US-A1- 2020 170 593

## Description

### TECHNICAL FIELD

The present disclosure generally relates to radiation detection devices, and more particularly, relates to photon-counting detectors for detecting radiation rays.

### BACKGROUND

A detector may be used for imaging in multiple fields such as medical imaging, industrial imaging, etc. Photonic detector technical currently has a large development prospect. For example, a photon-counting detector (PCD) may be used for a medical imaging device (e.g., an X-ray imaging device such as a computed tomography (CT) scanner) and the medical imaging device based on the photon-counting detector may have advantages such as realizing material component analysis, reducing a radiation dose of a subject, improving the accuracy of CT quantitative analysis, achieving an ultra-high spatial resolution, etc.

Therefore, it is desirable to provide an efficient photon-counting detector, improving the stability and reliability during the operation of the detector and reducing power consumption and the manufacturing cost of the detector.

### SUMMARY

In one aspect of the present invention, a photo-counting detector according to claim 1 is provided.

In another aspect of the present invention, a method for preparing a photo-counting detector according to claim 12 is provided.

Additional features will be set forth in part in the description which follows, and in part will become apparent to those skilled in the art upon examination of the following and the accompanying drawings or may be learned by production or operation of the examples. The features of the present disclosure may be realized and attained by practice or use of various aspects of the methodologies, instrumentalities, and combinations set forth in the detailed examples discussed below.

### BRIEF DESCRIPTION OF THE DRAWINGS

The present disclosure is further described in terms of exemplary embodiments. These exemplary embodiments are described in detail with reference to the drawings. These embodiments are non-limiting exemplary embodiments, in which like reference numerals represent similar structures throughout the several views of the drawings, and wherein:
FIG. 1A is a schematic diagram illustrating an exemplary imaging system according to some embodiments of the present disclosure;
FIG. 1B is a schematic diagram illustrating an exemplary imaging device according to some embodiments of the present disclosure;
FIG. 2A is a schematic diagram illustrating an exemplary photon-counting detector according to some embodiments of the present disclosure;
FIG. 2B is a schematic diagram illustrating an exemplary photon-counting detector according to some embodiments of the present disclosure;
FIG. 3A is a schematic diagram illustrating an exemplary chip according to some embodiments of the present disclosure;
FIG. 3B is a schematic diagram illustrating an exemplary chip according to some embodiments of the present disclosure;
FIG. 4 is a schematic diagram illustrating an exemplary Bosch process according to some embodiments of the present disclosure;
FIG. 5A is a schematic diagram illustrating exemplary TSVs according to some embodiments of the present disclosure;
FIG. 5B is a schematic diagram illustrating a partially enlarged view of part D of a TSV according to some embodiments of the present disclosure;
FIGs. 6A-6C are schematic diagrams illustrating cross-sections of exemplary plating layers according to some embodiments of the present disclosure;
FIG. 7 is a schematic diagram illustrating an exemplary chip according to some embodiments of the present disclosure;
FIG. 8 is a flowchart illustrating an exemplary process for obtaining a photon-counting detector according to some embodiments of the present disclosure;
FIG. 9 is a flowchart illustrating an exemplary process for preparing a photon-counting detector according to some embodiments of the present disclosure;
FIG. 10 is a schematic diagram illustrating an exemplary photon-counting detector according to some embodiments of the present disclosure;
FIG. 11 is a flowchart illustrating an exemplary process for preparing a photon-counting detector according to some embodiments of the present disclosure;
FIG. 12 is a schematic diagram illustrating an exemplary process for forming a redistribution layer, not according to the present invention;
FIG. 13 is a flowchart illustrating an exemplary process for preparing a photon-counting detector according to some embodiments of the present disclosure; and
FIG. 14 is a schematic diagram illustrating an exemplary process for forming a silicon interposer according to some embodiments of the present disclosure.

### DETAILED DESCRIPTION

In the following detailed description, numerous specific details are set forth by way of examples in order to provide a thorough understanding of the relevant disclosure. However, it should be apparent to those skilled in the art that the present disclosure may be practiced without such details. In other instances, well-known methods, procedures, systems, components, and/or circuitry have been described at a relatively high level, without detail, in order to avoid unnecessarily obscuring aspects of the present disclosure. Various modifications to the disclosed embodiments will be readily apparent to those skilled in the art, and the general principles defined herein may be applied to other embodiments and applications without departing from the spirit and scope of the present disclosure. Thus, the present disclosure is not limited to the embodiments shown, but to be accorded the widest scope consistent with the claims.

The terminology used herein is for the purpose of describing particular example embodiments only and is not intended to be limiting. As used herein, the singular forms "a," "an," and "the" may be intended to include the plural forms as well, unless the context clearly indicates otherwise. It will be further understood that the terms "comprise," "comprises," and/or "comprising," "include," "includes," and/or "including," when used in this specification, specify the presence of stated features, integers, steps, operations, elements, and/or components, but do not preclude the presence or addition of one or more other features, integers, steps, operations, elements, components, and/or groups thereof.

It will be understood that when a unit, engine, module, or block is referred to as being "on," "connected to," or "coupled to," another unit, engine, module, or block, it may be directly on, connected or coupled to, or communicate with the other unit, engine, module, or block, or an intervening unit, engine, module, or block may be present, unless the context clearly indicates otherwise. As used herein, the term "and/or" includes any and all combinations of one or more of the associated listed items.

These and other features, and characteristics of the present disclosure, as well as the methods of operation and functions of the related elements of structure and the combination of parts and economies of manufacture, may become more apparent upon consideration of the following description with reference to the accompanying drawings, all of which form a part of this disclosure. It is to be expressly understood, however, that the drawings are for the purpose of illustration and description only and are not intended to limit the scope of the present disclosure. It is understood that the drawings are not to scale.

For illustration purposes, the following description is provided to help better understand the present disclosure. It is understood that this is not intended to limit the scope of the present disclosure. For persons having ordinary skills in the art, a certain amount of variations, changes, and/or modifications may be deducted under the guidance of the present disclosure. Those variations, changes, and/or modifications do not depart from the scope of the present disclosure.

An aspect of the present disclosure relates to a photon-counting detector. The photon-counting detector may include a sensor layer, a chip, and a substrate. The sensor layer may be configured to detect incident radiation photons and generate electrical signals. The chip may be electrically connected with the sensor layer. The chip may also include a plurality of connection components through the chip and one or more processing circuits, wherein each of the one or more processing circuits are electrically connected with one or more parts of the sensor layer through at least one of the plurality of connection components. The substrate may be electrically connected with the chip.

According to some embodiments of the present disclosure, the photon-counting detector may be simplified by omitting a substrate between the sensor layer and the chip. The thickness of the photon-counting detector may be reduced, which reduces the difficulty of the package and reduces the cost of the package. In addition, the chip of the photon-counting detector may realize signal transmission between the sensor layer and a processing circuit of the chip via a silicon through-hole (TSV), which reduces an alignment length, further reducing power consumption and/or improving the reliability and stability of the photon-counting detector.

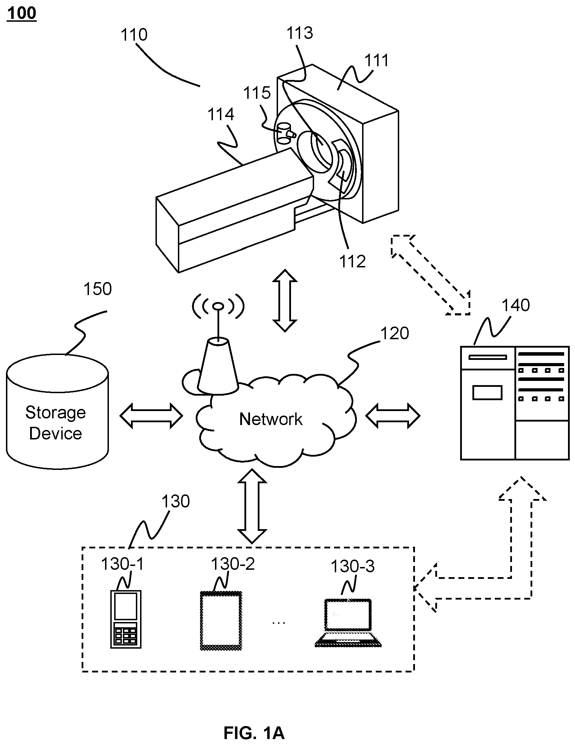

FIG. 1A is a schematic diagram illustrating an exemplary imaging system according to some embodiments of the present disclosure. As shown, the imaging system 100 may include an imaging device 110, a network 120, one or more terminals 130, a processing device 140, and a storage device 150. In some embodiments, the imaging device 110, the processing device 140, the storage device 150, and/or the terminal(s) 130 may be connected to and/or communicate with each other via a wireless connection (e.g., the network 120), a wired connection, or a combination thereof. The connection between the components in the imaging system 100 may be variable. Merely by way of example, the imaging device 110 may be connected to the processing device 140 through the network 120, as illustrated in FIG. 1A. As another example, the imaging device 110 may be connected to the processing device 140 directly. As a further example, the storage device 150 may be connected to the processing device 140 through the network 120, as illustrated in FIG. 1A, or connected to the processing device 140 directly.

The imaging device 110 may be configured to acquire image data relating to at least one part of a subject. The imaging device 110 may scan the subject or a portion thereof that is located within its detection region and generate image data (e.g., an initial image) relating to the subject or the portion thereof. The image data relating to at least one part of a subject may include an image (e.g., an image slice), projection data, or a combination thereof. In some embodiments, the imaging device 110 may include a single modality imaging device. For example, the imaging device 110 may include a CT device, an X-ray imaging device (e.g., a DR scanner, a computed radiography (CR) scanner), or the like, or any combination thereof. In some embodiments, the imaging device 110 may include a multi-modality imaging device. Exemplary multi-modality imaging devices may include a PET-CT device, a CT-guided radiotherapy device, etc. The following descriptions are provided unless otherwise stated expressly, with reference to a CT device for illustration purposes and not intended to be limiting.

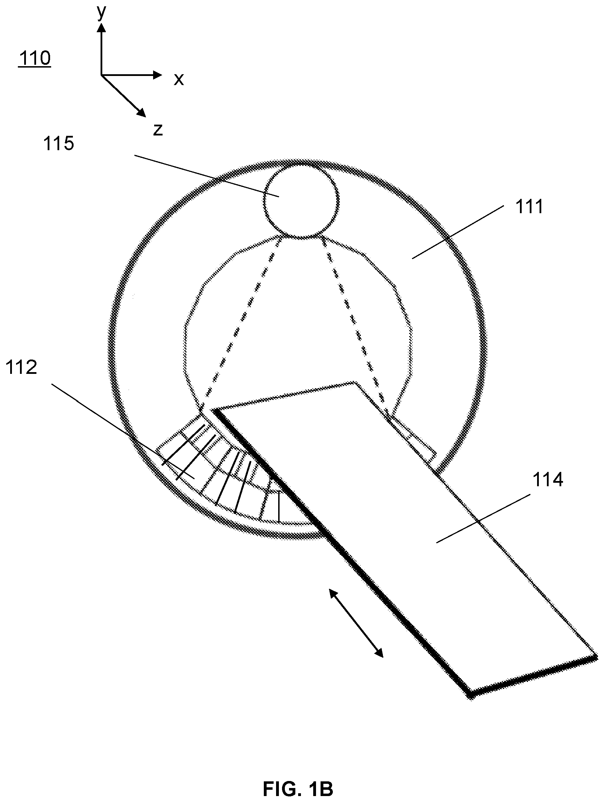

As illustrated, the imaging device 110 may include a supporting assembly 111, a detector assembly 112, a detecting region 113, a table 114, and a radiation emitting assembly 115. The supporting assembly 111 may support the detector assembly 112 and the radiation emitting assembly 115. The supporting assembly 111 may rotate, for example, clockwise or counterclockwise about an axis of rotation of the supporting assembly 111. The radiation emitting assembly 115 may rotate together with the supporting assembly 111. The subject may be placed on the table 114 and moved to the detecting region 113 along with a movement of the table 114. The radiation emitting assembly 115 may emit a beam of radiation rays (e.g., X-rays) to the subject. The detector assembly 112 may detect the radiation beam passing through the detecting region 113 without converting the radiation beam into visible lights. For example, the detector assembly 112 may convert radiation photons of the radiation beam directly into an electronic signal. The electronic signal may be transmitted to a computing device (e.g., the processing device 120) for processing, or transmitted to a storage device (e.g., the storage device 150) for storage. More descriptions for components of the imaging device 110 may be found elsewhere in the present in the present disclosure (e.g., FIGs. 1B-3B and the descriptions thereof).

The network 120 may include any suitable network that can facilitate the exchange of information and/or data for the imaging system 100. In some embodiments, one or more components (e.g., the imaging device 110, the terminal 130, the processing device 140, the storage device 150, etc.) of the imaging system 100 may communicate information and/or data with one or more other components of the imaging system 100 via the network 120. For example, the processing device 140 may obtain image data from the imaging device 110 via the network 120. As another example, the processing device 140 may obtain user instructions from the terminal 130 via the network 120. In some embodiments, the network 120 may include one or more network access points. For example, the network 120 may include wired and/or wireless network access points such as base stations and/or internet exchange points through which one or more components of the imaging system 100 may be connected to the network 120 to exchange data and/or information.

The terminal(s) 130 may include a mobile device 130-1, a tablet computer 130-2, a laptop computer 130-3, or the like, or any combination thereof. In some embodiments, the mobile device 130-1 may include a smart home device, a wearable device, a mobile device, a virtual reality device, an augmented reality device, or the like, or any combination thereof. In some embodiments, the terminal(s) 130 may be part of the processing device 140.

The processing device 140 may process data and/or information obtained from one or more components (the imaging device 110, the terminal(s) 130, and/or the storage device 150) of the imaging system 100. For example, the processing device 140 may process image data acquired by the imaging device 110 (e.g., image data detected by the detector assembly 112 (e.g., a photon-counting detector assembly) of the imaging device 110) and reconstruct an image based on the image data. In some embodiments, the processing device 140 may be a single server or a server group. The server group may be centralized or distributed. In some embodiments, the processing device 140 may be local or remote. For example, the processing device 140 may access information and/or data stored in the imaging device 110, the terminal(s) 130, and/or the storage device 150 via the network 120. As another example, the processing device 140 may be directly connected to the imaging device 110, the terminal(s) 130, and/or the storage device 150 to access stored information and/or data. In some embodiments, the processing device 140 may be implemented on a cloud platform. Merely by way of example, the cloud platform may include a private cloud, a public cloud, a hybrid cloud, a community cloud, a distributed cloud, an inter-cloud, a multi-cloud, or the like, or any combination thereof.

In some embodiments, the processing device 140 may be implemented by a computing device. For example, the computing device may include a processor, a storage, an input/output (I/O), and a communication port. The processor may execute computer instructions (e.g., program codes) and perform functions of the processing device 140 in accordance with the techniques described herein. The computer instructions may include, for example, routines, programs, objects, components, data structures, procedures, modules, and functions, which perform particular functions described herein. In some embodiments, the processing device 140, or a portion of the processing device 140 may be implemented by a portion of the terminal 130.

The storage device 150 may store data/information obtained from the imaging device 110, the terminal(s) 130, and/or any other component of the imaging system 100. In some embodiments, the storage device 150 may include a mass storage, a removable storage, a volatile read-and-write memory, a read-only memory (ROM), or the like, or any combination thereof. For example, the mass storage may include a magnetic disk, an optical disk, a solid-state drive, etc. The removable storage may include a flash drive, a floppy disk, an optical disk, a memory card, a zip disk, a magnetic tape, etc. In some embodiments, the storage device 150 may store one or more programs and/or instructions to perform exemplary methods described in the present disclosure.

In some embodiments, the storage device 150 may be connected to the network 120 to communicate with one or more other components in the imaging system 100 (e.g., the processing device 140, the terminal(s) 130, etc.). One or more components in the imaging system 100 may access the data or instructions stored in the storage device 150 via the network 120. In some embodiments, the storage device 150 may be directly connected to or communicate with one or more other components in the imaging system 100 (e.g., the processing device 140, the terminal(s) 130, etc.). In some embodiments, the storage device 150 may be part of the processing device 140.

FIG. 1B is a schematic diagram illustrating a view of an exemplary imaging device 110 according to some embodiments of the present disclosure. As shown in FIG. 1B, the detector assembly 112 and the radiation emitting assembly 115 may be both disposed on the supporting assembly 111. In some embodiments, the supporting assembly 111 may include a gantry. The gantry may include a housing and a bore. In some embodiments, the gantry may further include a main frame, one or more support components, or the like, or a combination thereof. The housing may form a cavity around the bore to accommodate one or more components of the imaging device 110 (e.g., the radiation emitting assembly 115, the detector assembly 112, the one or more support components, etc.). In some embodiments, the housing may include an annular structure. A detection region may be located within the annular structure. The detector assembly 112 and the radiation emitting assembly 115 may be located at both ends of the annular structure along a diameter direction, respectively. The detection region may accommodate the subject to be scanned. The subject to be scanned may be supported by the table 114. For example, the housing may include a front cover and a rear cover as described in FIG. 1B. The front cover and the rear cover may form the annular structure. The rear cover may enclose the bore. The front cover and the rear cover may define the cavity. The bore may be configured to accommodate an object for the scan. In other words, the bore may include a detection region (e.g., the detecting region 113) of the imaging device 110. In some embodiments, the radiation emitting assembly 115 and the detector assembly 112 may be located in the cavity along an opposite direction. In some embodiments, a line connecting a radiation source of the radiation emitting assembly 115 and the center of the detector assembly 112 may pass through the center of the detection region.

In some embodiments, the detector assembly 112 may include a detector. In some embodiments, the radiation emitting assembly 115 may include a radiation source. The radiation source may be configured to generate and/or emit radiation rays (e.g., X-rays) to scan the scanned object that is placed on the table 114. The detector may detect the radiation rays (e.g., X rays) penetrated through at least part of the scanned object within the detecting region. The detector may generate an electronic signal based on the detected radiation rays.

In some embodiments, the detector may include one or more photon-counting detectors. In some embodiments, a shape of the detector may not be limited. As used herein, the shape of the detector may refer to a surface of the detector facing the radiation source or a surface of the detector back to the radiation sources. In some embodiments, the shape of the detector may be a plate shape. In some embodiments, the shape of the detector may be an arc-shape. For example, the detector may be distributed along the circumferential direction of the bore.

In some embodiments, a photon-counting detector may include one or more components such as a sensor layer, and one or more readout electrical layers, etc. The photon-counting detector may operate in a photon-counting mode. During a scan for imaging, the sensor layer may be subjected to a large voltage. The sensor layer may absorb incident radiation photons (e.g., incident X-ray photons) and the incident radiation photons may generate clouds of positive charges and negative charges. The positive charges and negative charges may move under the large voltage. The moving charges may generate an electrical pulse (i.e., an electrical signal). The electrical pulse may be transmitted to the one or more readout electrical layers. The one or more readout electrical layers may receive the electrical pulse, process the electrical pulse for detecting the incident radiation photons and/or generate, based on the electrical pulse, electronic signals that include information (e.g., energies) of the incident radiation photons. Thus, the photon-counting detector may achieve converting the incident radiation photons directly into an electronic signal.

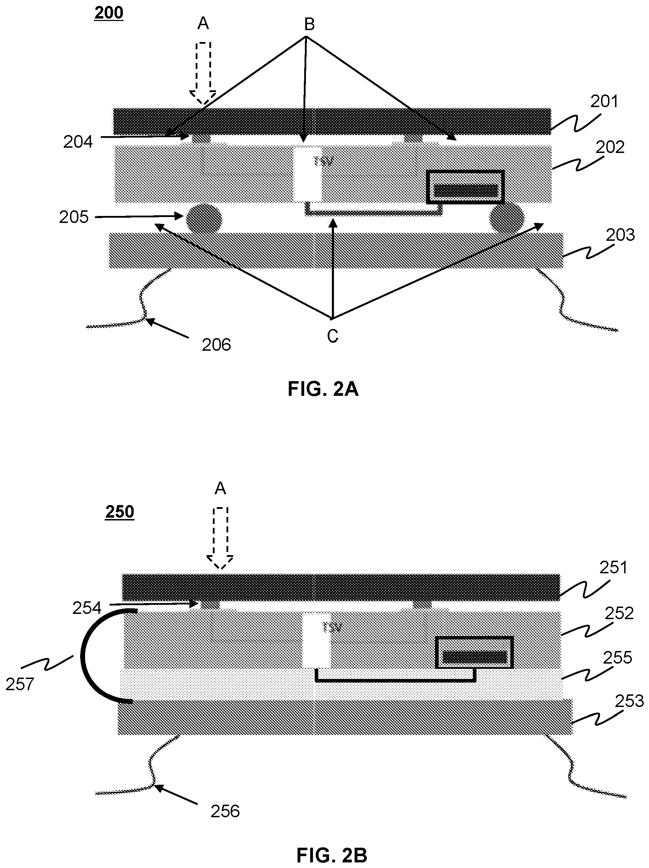

A readout electrical layer may include a substrate (e.g., a ceramic substrate, a resin substrate, etc.) and a processing circuit. Further, the substrate may be connected with the processing device 140. The processing circuit may be implemented on a chip. The chip may be communicatively connected with the sensor layer. The electrical pulse may be transmitted to the processing circuit. The substrate may provide support for the chip, receive the electronic signals including the information of the incident radiation photons from the one or more processing circuits and/or transmit the signal to the processing device 140 for subsequent processing (e.g., for image reconstruction). More descriptions for the photon-counting detector may be found elsewhere in the present disclosure (e.g., FIGs. 2A-8 and the descriptions thereof).

In some embodiments, the detector may include a plurality of detector rows distributed along the Z axis of the imaging device 110 as shown in FIG. 1B. Each of the plurality of detector rows may include a plurality of detector modules distributed along a direction substantially parallel to the X axis of the imaging device 110 as shown in FIG. 1B or a circumference direction of the bore of the imaging device 110.

In some embodiments, each of the plurality of detector modules may include one or more photon-counting detectors. For example, each of the one or more photon-counting detectors in a detector module may include a sensor layer, a chip, and a substrate.

In some embodiments, each of the plurality of detector modules may include one or more sensor layers, one or more chips, and one or more substrates.

In some embodiments, taking the photon-counting detector including a sensor layer, a substrate, and a processing circuit as an example, the processing circuit may be included in a chip, and the chip may be electrically connected with the sensor layer and the substrate, respectively. More descriptions regarding structures and positions of components of the photon-counting detector may be found elsewhere in the present disclosure (e.g., FIGs. 2A-3B and the descriptions thereof).

FIG. 2A is a schematic diagram illustrating an exemplary photon-counting detector according to some embodiments of the present disclosure. The photon-counting detector 200 may be an embodiment of a photon-counting detector as described in FIGs. 1A and 1B. The photon-counting detector 200 may be applied in or be a part of the imaging device 110 for imaging. For example, the imaging device 110 may include one or more photon-counting detectors 200. As illustrated in FIG. 2A, the photon-counting detector 200 may include a sensor layer 201, a chip 202, and a substrate 203. The chip 202 may be arranged between the sensor layer 201 and the substrate 203.

The sensor layer 201 may include a semiconductor layer. The semiconductor layer may include one or more crystalline materials. Exemplary crystalline materials may include silicon (Si), gallium arsenide (GaAs), cadmium telluride (CdTe), cadmium zinc telluride (CdTeZn), or the like, or any combination thereof. For example, the sensor layer 201 may include mono-crystals, e.g., including Si crystals. As another example, the sensor layer 201 may include poly-crystals, e.g., including CdTe crystals and CdTeZn crystals.

The sensor layer 201 may be configured to detect incident radiation photons and generate electrical signals (also referred to as first electrical signals). For example, the sensor layer 201 may be configured to absorb (or receive) the incident radiation photons (e.g., incident X-ray photons) for generating a first electrical signal (e.g., an electrical pulse). The indecent radiation photons may be generated by a radiation source (e.g., the radiation source of the radiation emitting assembly 115 as shown in FIGs. 1A and 1B) and transmit toward the sensor layer 201 after passing through a subject to be imaged. The sensor layer 201 may be attached to electrodes (not shown), e.g., the sensor layer 201 is arranged (or disposed) between a positive electrode (also referred to as an anode) and a negative electrode (also referred to as a cathode). The sensor layer 201 may be subjected to a large voltage by applying the large voltage to the electrodes. The incident radiation photons may irradiate along an incident direction on a surface of the sensor layer 201 attached to the negative electrode. For example, the incident direction may be parallel to a reference direction that is substantially perpendicular to surfaces of the sensor layer 201 that are attached to the electrodes. As another example, the incident direction may be angled with respect to the surface of the sensor layer that is attached to the negative electrode. The incident radiation photons may be converted into electron-hole pairs in the sensor layer 201 under the large voltage. The electrons of the electron-hole pairs may move toward a surface of the sensor layer 201 attached to the positive electrode, in response to which the positive electrode generates the first electrical signal. For illustration purposes, a direction that is substantially perpendicular to the surfaces of the sensor layer 201 that are attached to the electrodes may be designated as the reference direction (e.g., a direction denoted by dotted arrow A) for describing relative positions between the components of the photon-counting detector 200. In other words, the reference direction may refer to a direction that is substantially perpendicular to a surface of the sensor layer 201 that receives the incident radiation photons.

In some embodiments, an array of weld metal dots (or balls) 204 (also referred to as first weld metal dots) (e.g., silver (Ag) dots, tin (Sn) dots, etc.) may be connected with (e.g., printed on) the surface of the sensor layer 201 that is attached to the positive electrode. According to the array of the weld metal dots 204, the sensor layer 201 may be pixelated. Each of the weld metal dots 204 may correspond to a pixel. That is, the sensor layer 201 may form a pixel array according to the array of the weld metal dots 204. In response to the incident radiation photons, each of the weld metal dots 204 may transmit a first electrical signal corresponding to a pixel to the chip 202 for further transmitting and/or processing.

The chip 202 may be electrically connected with the sensor layer 201. The chip 202 may receive the first electrical signal from the sensor layer 201 through the weld metal dots 204. In some embodiments, the chip 202 may be electrically connected with the sensor layer 201 through a flip-chip bonding interconnection such as a conductive epoxy bonding interconnection, a cold-weld bump bonding interconnection, or the like, or any combination thereof. For the conductive epoxy bonding interconnection, the array of weld metal dots 204 may include an array of silver (Ag)-loaded epoxy dots, an array of copper (Cu)-loaded epoxy dots, an array of gold (Au)-loaded epoxy dots, etc. For example, the chip 202 and the sensor layer 201 with the array of silver (Ag)-loaded epoxy dots may be cured through a flip-chip bonder at a preset temperature (e.g., 45 degrees centigrade (°C)). Thus, the chip 202 may be electrically connected with the sensor layer 201 by the array of silver

(Ag)-loaded epoxy dots, and the chip 202 may receive the first electrical signal from the sensor layer 201. For the cold-weld bump bonding interconnection, the weld metal dots 204 may be replaced by bumps (also referred to as first bumps), such as indium (In) bumps, gold (Au) bumps, lead-tin (Pb-Sn) bumps, or the like, or any combination thereof. Taking the In bumps as an example, the In bumps may be deposited on the surface of the sensor layer 201 that is attached to the positive electrode and a surface of the chip 202 that is close to the positive electrode using a vacuum evaporation technique. Thus, the chip 202 may be electrically connected with the sensor layer 201 by the In bumps, and the chip 202 may receive the first electrical signal from the sensor layer 201 via the In bumps. In some embodiments, the space (e.g., spaces B as shown in FIG. 2A) between the array of weld metal dots 204 or the space between the first bumps may be filled with insulating resins. The insulating resins may have a property of good fluidity, such that the insulating resins may cover the connections (e.g., the array of weld metal dots 204 or the first bumps) between the chip 202 and the sensor layer 201, thereby reducing or avoiding disconnections between the chip 202 and the sensor layer 201 and further improving the reliability of the photon-counting detector 200. For instance, the insulating resins may include an adhesive, thereby improving a strength of the connection between the chip 202 and the sensor layer 201.

In some embodiments, the weld metal dots 204 may be connected with the chip 202 before the weld metal dots 204 are connected with the sensor layer 201. That is, the weld metal dots 204 disposed on the chip 202 may be covered with the conductive epoxy, and then the weld metal dots 204 may be connected with (e.g., printed on) the surface of the sensor layer 201 through the conductive epoxy.

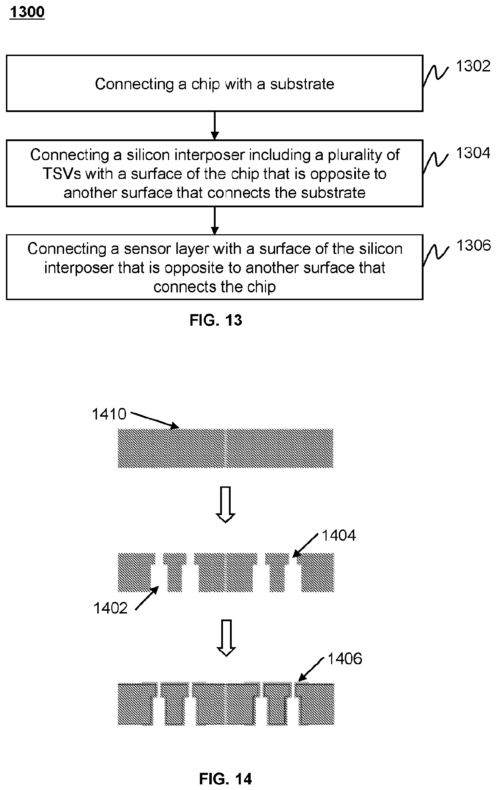

According to the invention, the chip 202 is electrically connected with the sensor layer 201 through a silicon interposer including a plurality of through-silicon vias (TSVs). The silicon interposer refers to an interposer made of silicon that defines a plurality of TSVs. Each of the plurality of TSVs in the silicon interposer may be substantially parallel to the reference direction, and the reference direction may be substantially perpendicular to a surface of the sensor layer 201 that receives the incident radiation photons. More descriptions regarding the silicon interposer may be found elsewhere in the present disclosure (e.g., FIGs. 13 and 14, and the descriptions thereof).

In some embodiments, the chip 202 may include a plurality of connection components through the chip 202 and one or more processing circuits. Each of the one or more processing circuits may be electrically connected with one or more parts of the sensor layer 201 through at least one of the plurality of connection components.

In some embodiments, the chip 202 may defines a through-silicon via (TSV) and at least partial of the plurality of connection components may be arranged within the TSV. The TSV may be substantially parallel to the reference direction (e.g., a direction denoted by dotted arrow A), and the reference direction may be substantially perpendicular to a surface of the sensor layer 201 that receives the incident radiation photons.

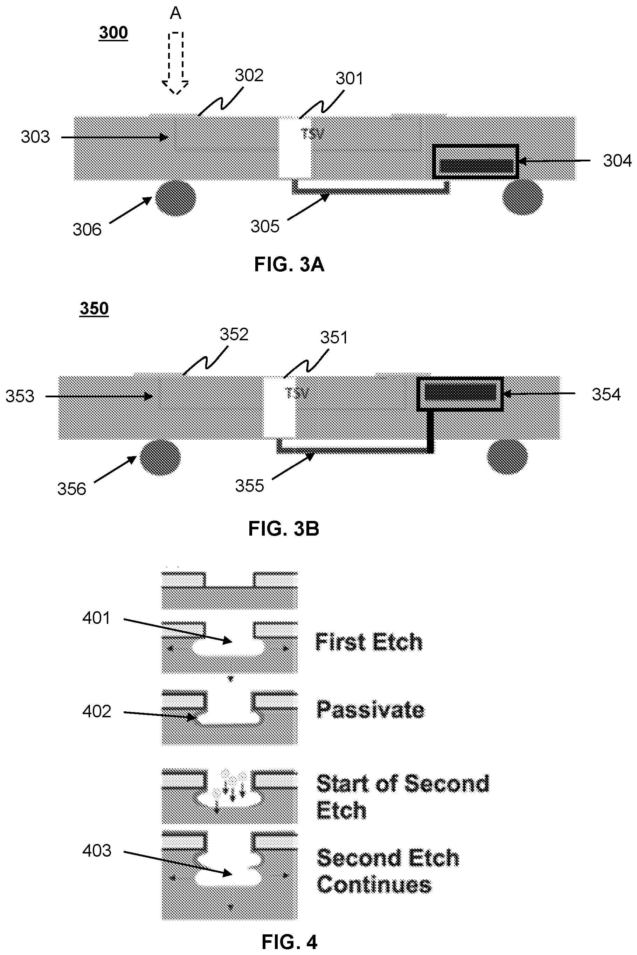

A processing circuit may include an integrated circuit such as an application-specific integrated circuit (ASIC), a universal integrated circuit, etc. In some embodiments, the processing circuit may be integrated as the chip 202. In some embodiments, the processing circuit may be configured to receive, through the TSV that is connected with the processing circuit, the first electrical signals of multiple pixels for determining information (e.g., energy) of the incident radiation photon. The information of the incident radiation photons may be used for subsequent processing (e.g., image reconstruction). More descriptions regarding structures of the chip may be found elsewhere in the present disclosure (e.g., FIGs. 3A and 3B and the descriptions thereof).

In some embodiments, the substrate 203 may be electrically connected with the chip 202 via a flip-chip bonding interconnection, a wire-bonding interconnection, or the like, or any combination thereof. Exemplary flip-chip bonding interconnections may include a conductive epoxy bonding interconnection, a cold-weld bump bonding interconnection, or the like, or any combination thereof. For the flip-chip bonding interconnection, as shown in FIG. 2A, the substrate 203 may be electrically connected with the chip 202 by an array of weld metal dots (or balls) 205 (also referred to as second weld metal dots) between the substrate 203 and the chip 202. A count (number) of the weld metal dots 205 may be the same as or different from that of the weld metal dots 204. The array of the weld metal dots 205 may be similar to the weld metal dots 204. For example, a material of the weld metal dots 205 may be the same as or different from that of the weld metal dots 204. Alternatively, the array of weld metal dots 205 may be replaced by bumps (also referred to as second bumps) (e.g., In bumps, Au bumps, Pb-Sn bumps, etc.). A count (number) of the weld metal dots 204 may be the same as or different from that of the second bumps. Thus, the substrate 203 may receive, via the array of weld metal dots 205 or the second bumps, a second electrical signal including the information of the incident radiation photons from the chip 202 (e.g., the one or more processing circuits) for outputting. The second electrical signal may refer to an electrical signal processed by the processing circuit. For example, the processing circuit may generate a second electrical signal based on a plurality of first electrical signals of one or more pixels for determining information of the incident radiation photon. In some embodiments, space (e.g., spaces C as shown in FIG. 2A) between the weld metal dots 205 or the space between the bumps may be filled with insulating resins. The insulating resins may have a property of good fluidity, such that the insulating resins may cover the connections (e.g., the array of weld metal dots 205 or the bumps) between the substrate 203 and processing circuit 203, thereby reducing or avoiding disconnections between the substrate 203 and the chip 202 and further improving the reliability of the photon-counting detector 200. For instance, the insulating resins may include an adhesive, thereby improving a strength of the connection between the substrate 203 and the chip 202.

For the wire-bonding interconnection, referring to FIG. 2B, FIG. 2B is a schematic diagram illustrating an exemplary photon-counting detector according to some embodiments of the present disclosure. The photon-counting detector 250 may be an embodiment of the photon-counting detector as described in FIG. 1A and FIG. 1B. The photon-counting detector 250 may be applied in or be a part of the imaging device 110 for imaging. As illustrated in FIG. 2B, the photon-counting detector 250 may include a sensor layer 251, a chip 252, and a substrate 253, which may be similar to or the same as the sensor layer 201, the chip 202, and the substrate 203 of the photon-counting detector 200, respectively. For example, the sensor layer 251 may be electrically connected with the chip 252 via weld metal dots 254 or first pumps, which is similar to or the same as the connection between the sensor layer 201 and the chip 202. The substrate 253 may be connected with one or more output interfaces 256 which is the same as or similar to the output interface(s) 206, for outputting the second electronic signal including the information of the incident radiation photons. More descriptions for the sensor layer 251, the chip 252, and the substrate 253 may be found elsewhere in the present disclosure (e.g., FIG. 2A).

As shown in FIG. 2B, a first region of the chip 252 may be connected with the substrate 253 via bonding (e.g., through a bonding agent 255), and a second region of the chip 252 may be electrically connected with the substrate 253 via the wire-bonding interconnection (e.g., through wire(s) 257). The first region of the chip 252 refers to a region on a surface of the chip 252 that is substantially perpendicular to the reference direction A and close to the substrate 253, and the second region of the chip 252 refers to a region on a surface of the chip 252 that is substantially perpendicular to the reference direction A and far away from the substrate 253. In such cases, the connection between the substrate 253 and the chip 252 may be an insulation connection. Thus, the substrate 253 may receive, via the wire(s) 257, the second electrical signal including the information of the incident radiation photons from the chip 202 for outputting. For example, the wire(s) 257 connecting the substrate 253 with the chip 252 may include a gold wire, an aluminum wire, a copper wire, or the like or any combination thereof. The bonding agent 255 connecting the substrate 253 with the chip 252 may include a resin adhesive such as an epoxy resin adhesive.

In some embodiments, the substrate 203 may include a printed circuit board (PCB), a flexible printed circuit (FPC), a rigid-flexible printed circuit board, etc. The PCB may one or more insulating materials. Exemplary insulating materials may include ceramic material, glass material (e.g., epoxy glass cloths), plastic material, paper material (e.g., phenolic papers), or the like, or any combination thereof.

In some embodiments, a thickness of the substrate 203 as shown in Fig. 2A along the reference direction A may be less than 1 millimeter, 0.9 millimeters, 0.85 millimeters, etc. The thickness of the substrate 203 may affect a power dissipation of the photon-counting detector. The greater the thickness of the substrate 203 is, the greater the power dissipation of the photon-counting detector may be, which may result in higher heat emission of the photon-counting detector. In some embodiments, the thickness of the substrate 203 may affect a warping level of a surface of the substrate 203 that is substantially perpendicular to the reference direction A. The less the thickness of the substrate 203 is, the greater a warping level of the substrate 203 may be. However, the warping level of a surface of the substrate 203 that is substantially perpendicular to the reference direction may need to be less than 40 microns, 35 microns, 30 microns, etc. Accordingly, to balance the needs of the power dissipation of the photon-counting detector and the warping level of a surface of the substrate 203, the thickness of the substrate 203 may be at least less than 1 millimeter, which may be a challenge to the manufacturing process and technology for the substrate 203.

In some embodiments, the substrate 203 may be made (or produced) at a low temperature (e.g., a temperature between room temperature and 200 °C). In some embodiments, the substrate 203 may be made under a relatively high temperature (e.g., 1000 °C). In some embodiments, the substrate 203 may correspond to a low dielectric constant (e.g., a dielectric constant less than a threshold).

In some embodiments, the substrate 203 may be configured to achieve data transmission between the processing circuit and one or more components (e.g., the processing device 140, the storage device 150, etc.) of the imaging device 110. For example, the substrate 203 may receive the second electronic signal including information of the incident radiation photons from the chip 202 (e.g., the processing circuit of the chip 202) through the weld metal dots 205 or the second bumps. The substrate 203 may output the electronic signal including information of the incident radiation photons (e.g., transmit the electronic signal including information of the incident radiation photons to the processing device 140).

In some embodiments, the substrate 203 may be configured for power supply for the chip 202. For example, the substrate 203 may include a power supply component (e.g., a lithium battery, a lead-acid battery, a supercapacitor, etc.), and the power supply component may supply power to the chip 202 through the substrate 203. As another example, the substrate 203 may be connected with an external power supply (e.g., a power generator), and the external power supply may supply power to the chip 202 through the substrate 203.

In some embodiments, the substrate 203 may be connected with one or more output interfaces 206 for outputting the second electronic signal including the information of the incident radiation photons. The output interface(s) 206 may include a standardized communication port, such as RS232, RS485, etc. In some embodiments, the output interface(s) 206 may be a specially designed communication port. For example, the output interface(s) 206 may be designed in accordance with the digital imaging and communications in medicine (DICOM) protocol.

According to some embodiments of the present disclosure, the photon-counting detector may be simplified by omitting a substrate between the sensor layer and the chip. Therefore, a thickness of the photon-counting detector 200 or the photon-counting detector 250 may be reduced, which reduces the difficulty of the package and reduces the cost of the package. For example, a thickness of the photon-counting detector 200 or the photon-counting detector 250 may be reduced to a range of 13 to 15 millimeters, which can improve the heat dissipation of the photon-counting detector 200 or the photon-counting detector 250, further adjusting a temperature of a system including the photon-counting detector 200 or the photon-counting detector 250.

It should be noted that the descriptions of the photon-counting detectors 200 and 250 are merely provided for the purposes of illustration, and not intended to limit the scope of the present disclosure. For persons having ordinary skills in the art, multiple variations and modifications may be made under the teachings of the present disclosure. However, those variations and modifications do not depart from the scope of the present disclosure. For example, any bonding interconnection that can achieve an electrical connection between the sensor layer 201 and the chip 202 may be used. As another example, the substrate 203 may be located between the sensor layer 201 and the chip 202.

FIG. 3A is a schematic diagram illustrating an exemplary chip of a photon-counting detector according to some embodiments of the present disclosure. The chip 300 may be an embodiment of a chip of the photon-counting detector as described in FIGs. 1A-2B. The chip 300 may be applied in or be a part of the photon-counting detector. As illustrated in FIG. 3A, the chip 300 may include a communication assembly and a processing circuit 304. The communication assembly may include a plurality of connection components, a plurality of bonding pads 302, a plurality of first connecting wires 303, a second connecting wire 305, and a plurality of weld metal dots 306. The communication assembly may realize a data transmission between a sensor layer and the processing circuit 304 in a photon-counting detector, and a data transmission between a substrate and the processing circuit 304 in the photon-counting detector. It should be noted that counts (or numbers) of the connection component and the processing circuit 304 are intended to be illustrative, and not to limit the scope of the present disclosure. The counts (or numbers) of the connection component and the processing circuit 304 may be determined, based on actual needs, respectively. For example, more than one processing circuit may be installed in the chip.

The chip 300 may define a through-silicon via (TSV) 301 and each of the plurality of connection components may be arranged within the TSV 301. The TSV 301 may be configured to achieve data (e.g., first electrical signals) transmission between the processing circuit 304 and a sensor layer (e.g., the sensor layer 201) of the photon-counting detector. For example, first electrical signals of multiple pixels for determining information of incident radiation photons may be transmitted from the sensor layer 201 to the processing circuit 304 through the TSV 301.

In some embodiments, the TSV 301 may form a first opening and a second opening. The first opening may be located on a first surface of the chip 300 that is connected with the sensor layer. For example, the first opening on the first surface of the chip 300 may be covered with an insulating material (e.g., insulating resins) and the insulating material may be connected with the sensor layer. The second opening may be located on a second surface of the chip 300 that is connected with a substrate (e.g., the substrate 203). For example, the second opening on the second surface of the chip 300 may be covered with an insulating material (e.g., insulating resins) and the insulating material may be connected with the substrate.

In some embodiments, a shape of the first opening may be the same as or substantially same as a shape of the second opening. The shape of the first opening may refer to a shape of a cross-section or a projection along a reference direction (e.g., a direction denoted by dotted arrow A) of the TSV 301 on the first surface of the chip 300, and the shape of the second opening may refer to a shape of a cross-section or a projection along the reference direction of the TSV 301 on the second surface of the chip 300. Exemplary shapes of the first opening and/or the second opening may include a regular shape (e.g., a square, a rectangle, a circle, an ellipse) or an irregular shape.

In some embodiments, an area of the first opening may be the same as or substantially same as an area of the second opening. Taking the shape of the first opening and/or the second opening being a circle as an example, a diameter of the first opening may be substantially equal to a diameter of the second opening. For example, a difference between the diameter of the first opening and the diameter of the second opening may be less than a difference threshold. The difference threshold may be determined based on actual needs. For instance, the difference threshold may be a value such as 0.5 microns, 1 micron, 1.5 microns, 2 microns, 2.5 microns, 3 microns, 3.5 microns, 4 microns, 4.5 microns, 5 microns, 6 microns, 7 microns, 8 microns, 9 microns, etc. As another example, a ratio of the diameter of the first opening and the diameter of the second opening may be within a ratio range. For instance, the ratio range may be a range such as a range from 0.70 to 1.30, a range from 0.75 to 1.25, a range from 0.80 to 1.20, a range from 0.85 to 1.15, a range from 0.90 to 1.10, a range from 0.95 to 1.05, etc.

In some embodiments, the TSV 301 may include a depth along the reference direction. The depth of the TSV 301 may be equal to a thickness of the chip 300. The depth of the TSV 301 may affect a strength of the chip 300, a difficulty of obtaining the TSV 301, a transmission distance of data (e.g., the first electrical signals), etc. For example, the larger the depth of the TSV 301 is, the greater the thickness of the chip 300 may be, but the larger the difficulty of obtaining the TSV 301 may be, the longer the transmission distance of the first electrical signals may be. Therefore, to balance the strength of the chip 300, the difficulty of obtaining the TSV 301, and the transmission distance of the first electrical signals, the depth may be equal to or greater than 200 microns. In some embodiments, the depth may be equal to or greater than 250 microns. In some embodiments, the depth may be equal to or greater than 300 microns.

In some embodiments, a ratio of the depth to a diameter of the TSV 301 may affect a strength of the chip 300, which may further affect a difficulty of assembly of the photon-counting detector. As used herein, the diameter of the TSV 301 refers to a diameter of a circumcircle of a cross-section or a projection along the reference direction (e.g., the direction denoted by dotted arrow A) of any location of the TSV 301. For example, the diameter of the TSV 301 may be the diameter of the first opening or the diameter of the second opening. Alternatively, the diameter of the TSV 301 refers to an average diameter of circumcircles of cross-sections or projections along the reference direction of multiple locations of the TSV 301. For example, the diameter of the TSV 301 may include an average diameter of the diameter of the first opening and the diameter of the second opening. The larger the ratio of the depth to the diameter of the first opening or the diameter of the second opening, the stronger the chip 300 may be. Therefore, the ratio of the depth to the diameter of the first opening or the diameter of the second opening may be greater or equal to 1.6. In some embodiments, the ratio of the depth to the diameter of the first opening or the diameter of the second opening may be greater or equal to 1.7. In some embodiments, the ratio of the depth to the diameter of the first opening or the diameter of the second opening may be greater or equal to 1.8. In some embodiments, the ratio of the depth to the diameter of the first opening or the diameter of the second opening may be greater or equal to 1.9. In some embodiments, the ratio of the depth to the diameter of the first opening or the diameter of the second opening may be greater or equal to 2.0. Accordingly, decreasing the diameter of the first opening or the diameter of the second opening may result in a larger ratio of the depth to the diameter of the first opening or the diameter of the second opening. However, as the diameter of the first opening or the diameter of the second opening decreases, the difficulty of the manufacturing process and technology for the chip 300 may be increased. Therefore, to balance the difficulty of the manufacturing process and technology for the chip 300 and the ratio of the depth to the diameter of the first opening or the diameter of the second opening, the diameter of the first opening or the diameter of the second opening may be in a range from 100 microns to 120 microns.

In some embodiments, an axis direction (i.e., an extension direction) of the TSV 301 may be substantially parallel to the reference direction (e.g., the direction denoted by dotted arrow A). The reference direction may be substantially perpendicular to a surface of a sensor layer (e.g., the sensor layer 201) that receives incident radiation photons. In some embodiments, the TSV 301 may pass through the chip 300 along the reference direction. For example, a centerline (i.e., an axis) of the TSV 301 may be substantially parallel to the reference direction.

The extension direction (i.e., the axis direction) of the TSV 301 may affect a transmission performance of the chip 300. For example, if the extension direction of the TSV 301 is not parallel to the reference direction, the transmission distance of data may be increased. The transmission distance may be associated with a length along the extension direction of the TSV 301. Therefore, the transmission time of the TSV 301 may be increased, and transmission stability of the TSV 301 may be decreased. In addition, if the extension direction of the TSV 301 is not parallel to the reference direction, a projection of the first opening along the reference direction may not overlap or partially overlap with the second opening, which may result in more difficulties in an arrangement (e.g., the arrangement of circuits) of the chip 300 and reduce the usage of the chip 300. Accordingly, to improve the transmission performance of the chip 300, the direction of the TSV 301 may be parallel to the reference direction, which may be a challenge to the manufacturing process and technology for the chip 300.

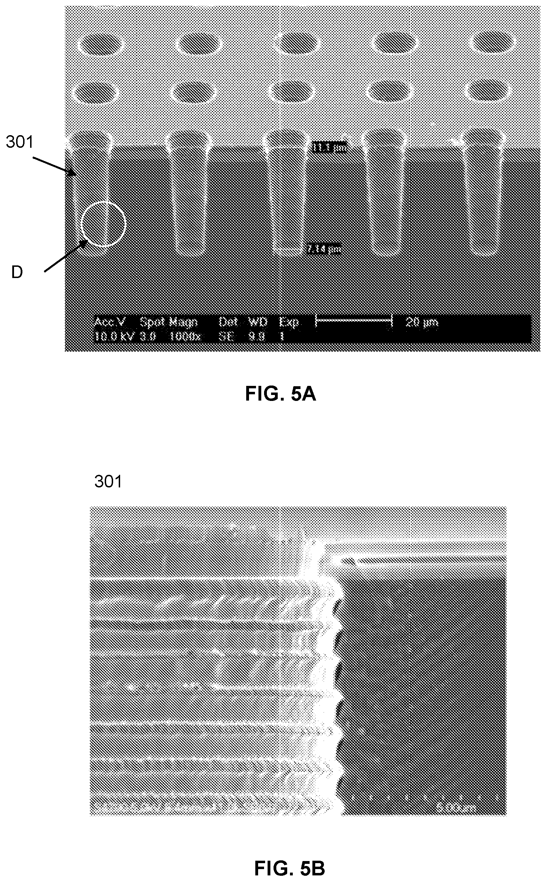

In some embodiments, the TSV 301 may be obtained by controlling a degree of etching. The degree of etching may be substantially equal to 90 degrees. For example, the TSV 301 may be obtained by a Bosch process. The Bosch process may alternate repeatedly between two modes (or processes) (an etching mode and a passivating mode) to achieve the TSV 301. Referring to FIG. 4, FIG. 4 is a schematic diagram illustrating an exemplary Bosch process according to some embodiments of the present disclosure. Etching gases may be injected to perform a first etch on a chip. After the first etch is performed, a first hole 401 may be formed. Passivation gases may be injected to passivate a sidewall of the first hole 401, and a passivation layer 402 may be formed on the sidewall of the first hole 401. Subsequently, the etching gases may be injected to perform a second etch on the chip, and a second hole 403 may be formed. Etching and sidewall passivation may be performed continuously, by alternating etching and passivation, until the TSV passes through the chip along the reference direction. Referring to FIG. 5A, FIG. 5A is a schematic diagram illustrating exemplary TSVs according to some embodiments of the present disclosure. The TSVs 301 may be obtained by the Bosch process. As shown in FIG. 5A, the degree D of etching is 85 degrees, and the diameter (11.1 microns) of the first opening is close to the diameter (7.14 microns) of the second opening.

In some embodiments, a sidewall of the TSV 301 may be controlled according to an etching process (e.g., the Bosch process). For example, the sidewall of the TSV 301 may include a uniform etching outline that is generated during the etching process. Referring to FIG. 5B, FIG. 5B is a schematic diagram illustrating a partially enlarged view of part D of a TSV according to some embodiments of the present disclosure. As shown in FIG. 5B, a sidewall of the TSV 301 may include a uniform scallop-shaped etching outline. The uniform etching outline of the TSV 301 may be easy to form uniform layers inside the TSV 301, which may improve the performance of the TSV 301.

In some embodiments, the TSV 301 may be deposited with an insulation layer, a barrier layer, a seed layer, a plating layer, or the like, or any combination thereof. For example, the sidewall (inner wall) of the TSV 301 may be deposited with an insulation layer, a barrier layer, a seed layer, and a plating layer in sequence.

The insulation layer may be configured to prevent leakage currents and breakdowns. For example, electromigration or diffusion of metal ions (e.g., copper ions) may be blocked by the insulation layer. In some embodiments, the insulation layer may include a silicon dioxide (SiO₂) layer that is deposited via plasma enhanced chemical vapor deposition (PECVD). The PECVD may refer to a chemical vapor deposition process. This process may be used to deposit thin films (e.g., the SiO₂ layer) from a gas state (vapor) to a solid state on a target (e.g., the side wall of the TSV 301).

The barrier layer may be configured to inhibit subsequent diffusion of the metal ions during a subsequent plating process and avoid detachment of the metal ions from the TSV 301 (e.g., the plating layer of the TSV 301). In some embodiments, the barrier layer may include a titanium (Ti) layer that is deposited via physical vapor deposition (PVD). The PVD may refer to a process in which a material goes from a condensed phase to a vapor phase and then back to a thin film condensed phase.

The seed layer may be used for subsequent plating to form the plating layer. The plating layer may be used as a conductive medium. In some embodiments, the seed layer may include a conductive metal material the same as the plating layer. For example, the seed layer may include a copper (Cu) layer, and the plating layer may also include a Cu plating layer.

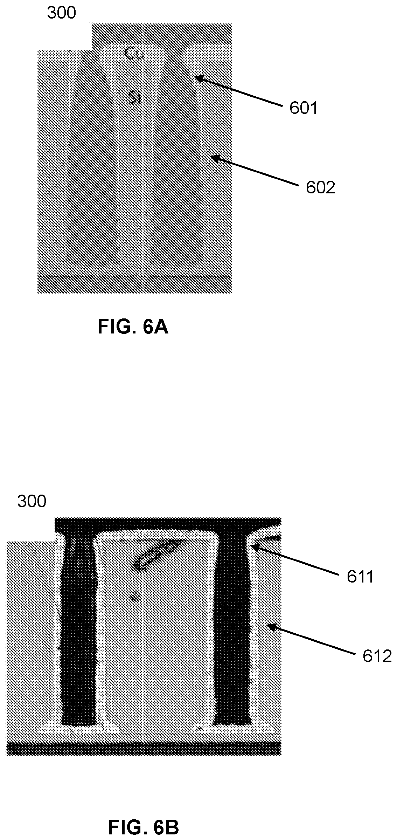

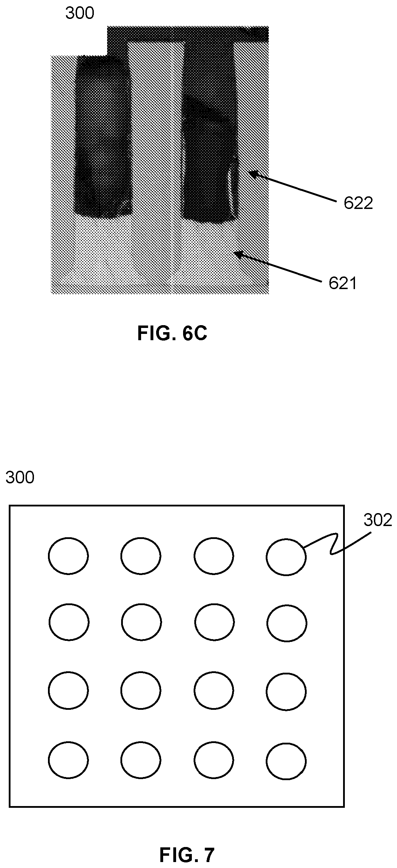

In some embodiments, a deposition thickness and/or a shape of each of the layers (e.g., the insulation layer, the barrier layer, the seed layer, the plating layer, etc.) may affect the performance of the TSV 301. Taking the plating layer as an example, referring to FIGs. 6A-6C, FIGs. 6A-6C are schematic diagrams illustrating cross-sections of exemplary plating layers according to some embodiments of the present disclosure. FIGs. 6A-6C may be cross-sections of the chip 300 along a plane perpendicular to a first surface of the chip 300, respectively. As shown in FIG. 6A, a plating layer 601 is under a subconformal state. The subconformal state may refer to a state that does not reach a conformal state. In the subconformal state, a portion of a surface may not be covered by a layer, or a thickness of the layer may not reach a first thickness threshold. The first thickness threshold may refer to a minimum thickness of the layer. The plating layer (e.g., the Cu layer) 601 may be deposited on an upper portion of a TSV 602 (e.g., the insulation layer, the barrier layer, etc., of the TSV 602), which may result in a disconnection of a sensor layer (e.g., the sensor layer 201) and a processing circuit (e.g., the processing circuit 304), so that data (e.g., first electrical signals) cannot be transmitted from the sensor layer to the processing circuit. As shown in FIG. 6B, a plating layer 611 is under a conformal state. In the conformal state, the surface may be covered by the layer, and the thickness of the layer may be uniform and within a range from the first thickness threshold to a second thickness threshold. The second thickness threshold may refer to a maximum thickness of the layer. The plating layer 611 may be uniformly deposited on the entire of the TSV 612 (e.g., the insulation layer, the barrier layer, etc., of the TSV 612), which may result in a stable connection of the sensor layer (e.g., the sensor layer 201) and the processing circuit (e.g., the processing circuit 304), so that data (e.g., first electrical signals) can be transmitted from the sensor layer to the processing circuit. As shown in FIG. 6C, a plating layer 621 is under a superconformal state. The superconformal state refers to a state that exceeds the conformal state. In the superconformal state, the thickness of the layer covered the surface may be larger than a second thickness threshold. The plating layer 621 may be deposited on a lower portion of a TSV 622 (e.g., the insulation layer, the barrier layer, etc., of the TSV 622), which may result in a disconnection of the sensor layer (e.g., the sensor layer 201) and the processing circuit (e.g., the processing circuit 304), so that data (e.g., first electrical signals) cannot be transmitted from the sensor layer to the processing circuit. Therefore, the uniform deposition thickness and a conformal shape of each of the layers (e.g., the insulation layer, the barrier layer, the seed layer, the plating layer, etc.) may improve the performance of the TSV 301.

In some embodiments, the chip 300 may be made of a wafer, and the plurality of TSVs 301 may be formed in the chip 300 by thinning the wafer. For example, before the etching process, the chip 300 may be thinned, so that the thickness of the chip 300 is equal to 200 microns. As another example, before the etching process, regions of the plurality of TSVs 301 may be determined, and the regions of the chip 300 may be thinned.

In some embodiments, the plurality of bonding pads 302 may be electrically connected with the TSV 301 through the plurality of first connecting wires 303, respectively. A count (or number) of the plurality of bonding pads 302 connected with the TSV 301 may be determined based on actual needs (e.g., positions of pads 302, a position of the TSV 301, first electrical signals of multiple pixels, etc.). A material of each of the plurality of first connecting wires 303 may include a copper wire, an aluminum wire, a silver wire, a gold wire, or the like, or any combination thereof.

The plurality of bonding pads 302 may be located on the first surface of the chip 300. For example, each of the plurality of bonding pads 302 may be welded on the first surface of the chip 300. As another example, each of the plurality of bonding pads 302 may be bonded on the first surface of the chip 300 through a bonding connection. In some embodiments, each of the plurality of bonding pads 302 may be electrically connected with the sensor layer via one of a flip-chip bonding interconnection and a wire-bonding interconnection. More descriptions regarding the bonding interconnection may be found elsewhere in the present disclosure (e.g., FIGs. 2A, 2B, and the descriptions thereof). In some embodiments, a count (or number) of the plurality of bonding pads 302 may be equal to a count of weld metal dots (e.g., the weld metal dots 204) or bumps (e.g., In bumps, Au bumps, etc., of the sensor layer). For example, each of the plurality of bonding pads 302 may correspond to one of the weld metal dots. Referring to FIG. 7, FIG. 7 is a schematic diagram illustrating an exemplary chip according to some embodiments of the present disclosure. The chip 300 shown in FIG. 7 may be viewed from the sensor layer along the reference direction A as shown in FIG. 3A. The chip 300 may include a plurality of bonding pads 302. The plurality of bonding pads 302 may be disposed in an array corresponding to the weld metal dots. In some embodiments, the count (or number) of the plurality of bonding pads 302 may be different from the count of weld metal dots or the bumps of the sensor layer. For example, the count (or number) of the plurality of bonding pads 302 may be larger than the count of weld metal dots or the bumps, so that each of the weld metal dots may be connected with one pad 302 based on a distance between the weld metal dot and each pad 302.

In some embodiments, the TSV 301 may be electrically connected with the processing circuit 304 through the second connecting wire 305. In some embodiments, the chip may be configured with multiple processing circuits and multiple TSVs. Each processing circuit may correspond to one TSV. A material of the second connecting wires 305 may include a copper wire, an aluminum wire, a silver wire, a gold wire, or the like, or any combination thereof.

The processing circuit 304 may include an integrated circuit such as an application-specific integrated circuit (ASIC). In some embodiments, the processing circuit 304 may be integrated in the chip 300. In some embodiments, the processing circuit 304 may be configured to receive, through the TSV 301 that is connected with the processing circuit 304, the first electrical signals of multiple pixels for determining information (e.g., energy) of the incident radiation photon. The information of the incident radiation photons may be used for subsequent processing (e.g., image reconstruction).

In some embodiments, the processing circuit 304 may include a plurality of processing units. A count (number) of the plurality of processing units may be equal to a count(number) of the metal dots (or a count(number) of the bonding pads 302). Each of the plurality of processing units may correspond to a pixel. Each of the plurality of processing units may be configured to process a first electrical signal corresponding to the pixel for determining information of the incident radiation photons corresponding to the pixel.

In some embodiments, the processing circuit 304 may include an amplifier, a threshold comparator, a counter, a readout circuit, etc. The amplifier (e.g., a charge-sensitive amplifier) may amplify the electrical signal generated by the positive electrode and send the amplified electrical signal to the comparator. The comparator may compare the signal amplitude of the amplified electrical signal with an amplitude threshold. If a signal amplitude of the amplified electrical signal is larger than the amplitude threshold, the counter may add a count. Since a count (or number) of the electrical-hole pairs is proportional to the energy of incident radiation photons, a signal amplitude output from the amplifier may be also proportional to the energy of the radiation incident photons. Therefore, the amplitude threshold of the comparator may be directly related to the energy of the incident radiation photons. In some embodiments, by changing the amplitude threshold of the comparator from small to large (or from large to small) and performing a plurality of measurements, information (e.g., flow rates and/or energy spectra of different energy) of the incident radiation photons may be obtained by processing signal amplitudes output from the amplifier using mathematical manners. Then, the readout circuit may output a signal including the information of the incident radiation photons.

In some embodiments, as shown in FIG. 3A, the processing circuit 304 may be located on the second surface of the chip 300. Each of the plurality of TSVs 301 may be formed by etching from the first surface of the chip 300 to the second surface of the chip 300, so that thinning a wafer to obtain the chip 300 may not affect the processing circuit 304. The TSV 301 may be obtained no matter before or after the processing circuit 304 is disposed on the chip 300. The substrate (e.g., the substrate 203) may be connected with the chip 300 before the TSVs 301 are obtained, which may simplify a manufacturing process and improve reliability of the photon-counting detector.

In some embodiments, the processing circuit 304 may be located on the first surface of the chip 300. Each of the plurality of TSVs 301 may be formed by etching from the second surface of the chip 300 to the first surface of the chip 300. The TSV 301 may be obtained before or after the processing circuit 304 is disposed on the chip 300. The substrate (e.g., the substrate 203) may be connected with the chip 300 after the TSVs 301 are obtained, which may complicate a manufacturing process and decrease reliability of the photon-counting detector. More descriptions regarding the processing circuit that is located on the first surface of the chip may be found elsewhere in the present disclosure (e.g., FIG. 3B and the description thereof).

The plurality of weld metal dots 306 may be configured to connect the chip 300 with a substrate (e.g., the substrate 203). In some embodiments, the plurality of weld metal dots 306 may be electrically connected with the substrate via a flip-chip bonding interconnection, a wire-bonding interconnection, or the like, or any combination thereof. Exemplary flip-chip bonding interconnections may include a conductive epoxy bonding interconnection, a cold-weld bump bonding interconnection, or the like, or any combination thereof. More descriptions regarding the bonding interconnection may be found elsewhere in the present disclosure (e.g., FIGs. 2A, 2B and the description thereof).

FIG. 3B is a schematic diagram illustrating an exemplary chip 350 of a photon-counting detector according to some embodiments of the present disclosure. The chip 350 may be an embodiment of a chip of the photon-counting detector as described in FIGs. 1A-2B. The chip 350 may be applied in or be a part of the photon-counting detector. As illustrated in FIG. 3B, the chip 350 may include a communication assembly and a processing circuit 354. The communication assembly may include a plurality of connection components, a plurality of bonding pads 352, a plurality of first connecting wires 353, a second connecting wire 355, and a plurality of weld metal dots 356. The chip 350 may define a through-silicon via (TSV) 351 and each of the plurality of connection components may be arranged within the TSV 351. The communication assembly may realize a data transmission between a sensor layer and the processing circuit 354 in a photon-counting detector, and a data transmission between a substrate and the processing circuit 354 in the photon-counting detector. The TSV 351, the plurality of bonding pads 352, the plurality of first connecting wires 353, the processing circuit 354, the second connecting wire 355, and the plurality of weld metal dots 356 in the chip 350 may be similar to or the same as the TSV 301, the plurality of bonding pads 302, the plurality of first connecting wires 303, the processing circuit 304, the second connecting wire 305, and the plurality of weld metal dots 306 in the chip 300, respectively. For example, the TSV 351 may be electrically connected with a sensor layer via the plurality of bonding pads 352 and the plurality of first connecting wires 353, which is similar to or the same as the connection between the sensor layer and the TSV 301. The TSV 351 may be electrically connected with the processing circuit 354 via the second connecting wire 355, which is the same as or similar to the connection between the processing circuit 354 and the TSV 351. More descriptions regarding the communication assembly and the processing circuit 354 may be found elsewhere in the present disclosure (e.g., FIG. 3A).

A difference between the chip 300 and the chip 350 may include that the processing circuit 304 may be located on the second surface of the chip 300, while the processing circuit 354 may be located on the first surface of the chip 350. Therefore, each of the plurality of TSVs 351 may be formed by etching from the second surface of the chip 350 to the first surface of the chip 350. In such a case, the processing circuit 354 may be located on a same surface as other components (e.g., the plurality of bonding pads 352, etc.). The TSV 351 may be obtained no matter before or after the processing circuit 304 is disposed on the chip 300. Since each of the plurality of TSVs 351 is formed by etching from the second surface of the chip 350 to the first surface of the chip 350, the substrate needs to be connected with the chip 350 after the TSVs 351 are obtained, which may increase the complexity of a manufacturing process. Since the plurality of bonding pads 352 connected with the TSV 351 are used to transmit the first electrical signals corresponding to multiple pixels, a large number of the plurality of bonding pads 352 may be disposed on the first surface of the chip 350, which may increase a difficulty of connecting the second connecting wire 355 to the plurality of bonding pads 352, thereby further increasing the complexity of a manufacturing process.

It should be noted that the descriptions of the chip 300 and the chip 350 are merely provided for the purposes of illustration, and not intended to limit the scope of the present disclosure. For persons having ordinary skills in the art, multiple variations and modifications may be made under the teachings of the present disclosure. However, those variations and modifications do not depart from the scope of the present disclosure.

In some embodiments, the chip 300 and the chip 350 may include more than one processing circuit. For example, the chip 300 and the chip 350 may include two processing circuits, three processing circuits, etc. In such cases, the chip 300 and the chip 350 may include two corresponding TSVs, three corresponding TSVs, etc.

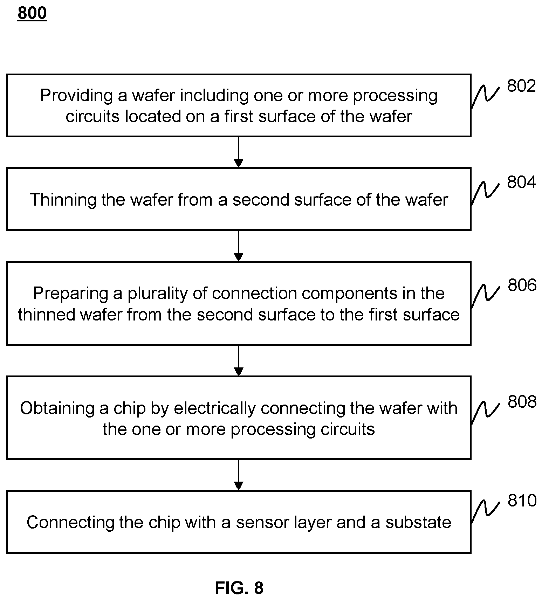

FIG. 8 is a flowchart illustrating an exemplary process for obtaining a photon-counting detector according to some embodiments of the present disclosure. The operations of the illustrated process presented below are intended to be illustrative. In some embodiments, the process 800 may be accomplished with one or more additional operations not described, and/or without one or more of the operations discussed. Additionally, the order in which the operations of the process 800 as illustrated in FIG. 8 and described below is not intended to be limiting.

In 802, a wafer including one or more processing circuits located on a first surface of the wafer may be provided.

The wafer may be obtained directly from the market or after a pretreatment (e.g., cleaning, grinding, etc.).

Each of the one or more processing circuits may be configured to receive first electrical signals of multiple pixels for determining information of incident radiation photon. More descriptions regarding the processing circuit may be found elsewhere in the present disclosure (e.g., FIGs. 1A-3B).

The one or more processing circuits may be located on the first surface of the wafer. For example, each of the one or more processing circuits may be welded on the first surface of the wafer. As another example, each of the one or more processing circuits may be bonded on the first surface of the chip through a bonding connection. It should be noted that the one or more processing circuits located on the first surface of the wafer are intended to be illustrative, and not to limit the scope of the present disclosure. For example, the one or more processing circuits may be located on a second surface of the wafer.

In 804, the wafer may be thinned from a second surface of the wafer.

The second surface may indicate a surface opposite to the first surface.

Exemplary thinning techniques may include grinding, lapping, polishing (e.g., chemical polishing, mechanical polishing, dry polishing, etc.), etching (e.g., electrochemical etching, wet etching, plasma enhanced chemical etching, atmospheric pressure plasma etching, etc.), or the like, or any combination thereof.

In some embodiments, a thickness of the thinned wafer after being thinned may be equal to or greater than 200 microns.

In 806, a plurality of connection components in the thinned wafer may be prepared from the second surface to the first surface.

One of the plurality of connection components may include a plurality of through-silicon vias (TSVs). The TSV may be substantially parallel to a reference direction. The reference direction may be substantially perpendicular to a surface of a sensor layer that receives incident radiation photons. In some embodiments, the TSV may be obtained by controlling a degree of etching to be substantially equal to 90 degrees. For example, the TSV may be obtained by a Bosch process. The Bosch process may alternate repeatedly between two modes (or processes) (an etching mode and a passivating mode) to achieve the TSV. For instance, etching gases may be injected to perform a first etch on a chip. After the first etch is performed, a first hole may be formed. Passivation gases may be injected to passivate a sidewall of the first hole, and a passivation layer may be formed on the sidewall of the first hole. Subsequently, the etching gases may be injected to perform a second etch on the chip, and a second hole may be formed. Etching and sidewall passivation may be performed continuously, by alternating etching and passivation, until the TSV passes through the chip along the reference direction.

In some embodiments, after the TSV is obtained, the TSV may be deposited an insulation layer, a barrier layer, a seed layer, a plating layer, or the like, or any combination thereof. The insulation layer may be configured to prevent leakage currents and breakdowns. The barrier layer may be configured to inhibit subsequent diffusion of the metal ions during a subsequent plating process and avoid detachment of the metal ions from the TSV (e.g., the plating layer of the TSV). The seed layer may be used for subsequent plating to form the plating layer. The plating layer may be used as a conductive medium. More descriptions regarding the TSV and the obtaining the TSV may be found elsewhere in the present disclosure (e.g., FIG. 3A).

In 808, a chip may be obtained by electrically connecting the wafer with the one or more processing circuits.

In some embodiments, the wafer may be electrically connected with the one or more processing circuits through one or more communication assemblies, respectively. Each of the one or more communication assemblies may include a plurality of connection components, a plurality of bonding pads, a plurality of first connecting wires, a second connecting wire, a plurality of weld metal dots, etc. Each of the plurality of connection components may be arranged within the TSV.

After the plurality of connection components (e.g., TSVs) is electrically connected with the one or more processing circuits, respectively, the wafer may be considered as already electrically connected to the one or more processing circuits. More descriptions regarding the chip may be found elsewhere in the present disclosure (e.g., FIGs. 2A-3B and the descriptions thereof).

In 810, the chip may be connected with the sensor layer and a substrate.

In some embodiments, the chip may be electrically connected with the sensor layer and the substrate via a flip-chip bonding interconnection, a wire-bonding interconnection, or the like, or any combination thereof. More descriptions regarding the bonding interconnection may be found elsewhere in the present disclosure (e.g., FIGs. 2A-3B and the descriptions thereof).

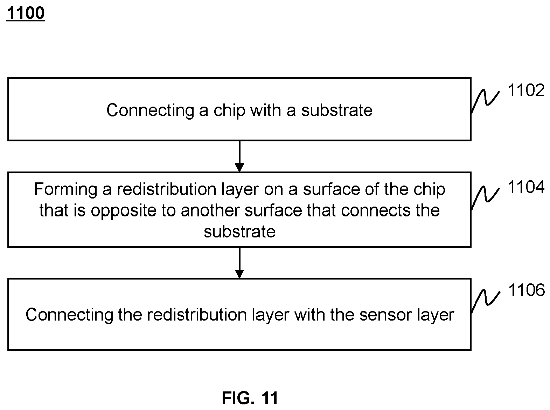

According to the invention, the chip may be electrically connected with the sensor layer and the substrate through a silicon interposer including a plurality of TSVs. The redistribution layer refers to a layer with multi-layer interconnection and flat expansion. The silicon interposer may refer to an interposer made of silicon that defines a plurality of TSVs. More descriptions regarding the bonding interconnection may be found elsewhere in the present disclosure (e.g., FIGs. 11-14 and the descriptions thereof).

It should be noted that the above description is merely provided for the purposes of illustration, and not intended to limit the scope of the present disclosure. For persons having ordinary skills in the art, multiple variations and modifications may be made under the teachings of the present disclosure. However, those variations and modifications do not depart from the scope of the present disclosure. For example, operation 804 and operation 806 may be performed before operation 802.

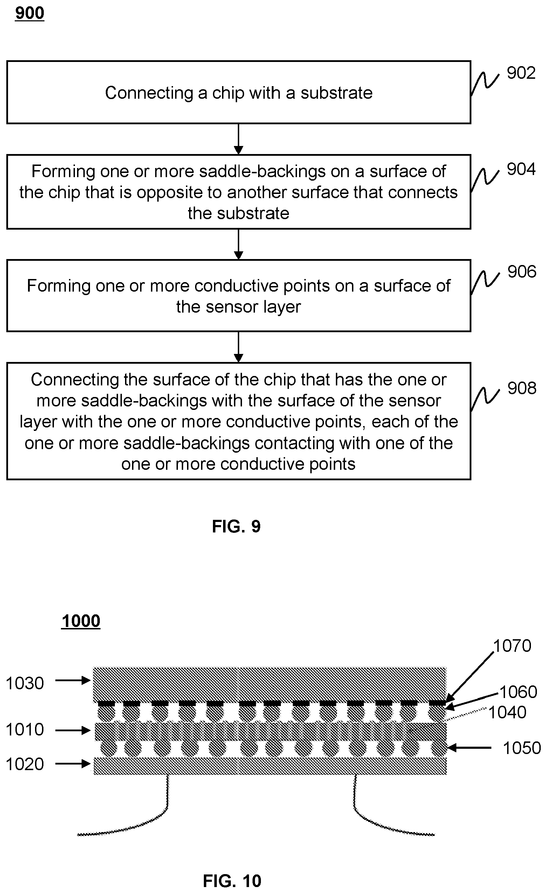

FIG. 9 is a flowchart illustrating an exemplary process 900 for preparing a photon-counting detector according to some embodiments of the present disclosure. The operations of the illustrated process presented below are intended to be illustrative. In some embodiments, the process 900 may be accomplished with one or more additional operations not described, and/or without one or more of the operations discussed. Additionally, the order in which the operations of the process 900 as illustrated in FIG. 9 and described below is not intended to be limiting.

In 902, a chip may be connected with a substrate.

The chip may refer to a wafer electrically connected with the one or more processing circuits through one or more communication assemblies, respectively. Each of the one or more communication assemblies may include a plurality of connection components, a plurality of bonding pads, a plurality of first connecting wires, a second connecting wire, a plurality of weld metal dots, etc. The chip may define a through-silicon via (TSV) and each of the plurality of connection components may be arranged within the TSV. The obtaining of the chip may be similar to the obtaining of the chip as described in FIG. 8.

The substrate may include a printed circuit board (PCB), a flexible printed circuit (FPC), a rigid-flexible printed circuit board, etc. The PCB may one or more insulating materials. Exemplary insulating materials may include ceramic material, glass material (e.g., epoxy glass cloths), plastic material, paper material (e.g., phenolic papers), or the like, or any combination thereof. More descriptions regarding the substrate may be found elsewhere in the present disclosure (e.g., FIGs. 2A-2B and the descriptions thereof).

In some embodiments, the chip may be connected with the substrate via a flip-chip bonding interconnection, a wire-bonding interconnection, or the like, or any combination thereof. Exemplary flip-chip bonding interconnections may include a conductive epoxy bonding interconnection, a cold-weld bump bonding interconnection, or the like, or any combination thereof. More descriptions regarding the bonding interconnection may be found elsewhere in the present disclosure (e.g., FIGs. 2A-2B and the descriptions thereof).

In some embodiments, after the chip is connected with the substrate, an adhesive may be filled between a surface of the chip that connects with the substrate and the substrate. For example, referring to FIG. 2A, space (e.g., spaces C as shown in FIG. 2A) between the weld metal dots 205 or the space between the bumps may be filled with the adhesive, such that the adhesive may cover the connections (e.g., the array of weld metal dots 205 or the bumps) between the substrate 203 and processing circuit 203, thereby reducing or avoiding disconnections between the substrate 203 and the chip 202, improving a strength of the connection between the substrate 203 and the chip 202, and further improving the reliability of the photon-counting detector 200.

In 904, one or more saddle-backings may be formed on a surface of the chip that is opposite to another surface that connects the substrate.

In some embodiments, the one or more saddle-backings may be formed via a wire bonding interconnection. Exemplary wire bonding interconnections may include a thermocompression bonding interconnection, an ultrasonic bonding interconnection, a thermoacoustic bonding interconnection, or the like, or any combination thereof. Merely by way of example, a wire (e.g., a gold wire, a copper wire, an aluminum wire, etc.) may be contacted with the surface of the chip that is opposite to the another surface that connects the substrate. Plastic deformation at an interface between the wire and the surface of the chip may be caused by heating, pressurizing, ultrasound, etc., so that the wire and the surface of the chip are fused to form a saddle-backing. A material of the saddle-backing may be consistent with a material of the wire. For example, if the wire is a gold wire, the saddle-backing may be a gold saddle-backing.

In some embodiments, the one or more saddle-backings may be formed via a flip-chip bonding interconnection. For example, the one or more saddle-backings may include epoxy dots, weld metal dots (or balls), bumps, or the like, or any combination thereof.

In 906, one or more conductive points may be formed on a surface of a sensor layer.

The one or more conductive points may be connected with (e.g., printed on) the surface of the sensor layer that is attached to the positive electrode. According to the one or more conductive points, the sensor layer may be pixelated. Each of the one or more conductive points may correspond to a pixel.

In some embodiments, the one or more conductive points may be formed via a conductive epoxy bonding interconnection, a cold-weld bump bonding interconnection, or the like, or any combination thereof. For the conductive epoxy bonding interconnection, the one or more conductive points may include one or more silver (Ag)-loaded epoxy dots, one or more copper (Cu)-loaded epoxy dots, one or more gold (Au)-loaded epoxy dots, etc. For the cold-weld bump bonding interconnection, the one or more conductive points may include bumps, such as indium (In) bumps, gold (Au) bumps, lead-tin (Pb-Sn) bumps, or the like, or any combination thereof.

In 908, the surface of the chip that has the one or more saddle-backings may be connected with the surface of the sensor layer with the one or more conductive points.

In some embodiments, each of the one or more saddle-backings may be connected with one of the one or more conductive points. For example, a count of the one or more saddle-backings may be the same as a count of the one or more conductive points, and a position of each of the one or more saddle-backings may correspond to a position of one of the one or more conductive points.

In some embodiments, the surface of the chip that has the one or more saddle-backings may be connected with the surface of the sensor layer with the one or more conductive points via a flip-chip boning interconnection. For example, one saddle-backing (e.g., a gold saddle-backing) may be cured with one conductive point (e.g., an Ag-loaded epoxy dot) at a preset temperature (e.g., 45 degrees centigrade (°C)). More descriptions regarding the bonding interconnection may be found elsewhere in the present disclosure (e.g., FIGs. 2A-2B and the descriptions thereof).

After the surface of the chip that has the one or more saddle-backings is connected with the surface of the sensor layer with the one or more conductive points, the combination of the substrate, the chip, and the sensor layer may be considered as a photon-counting detector. That is, the photon-counting detector may be obtained.

In some embodiments, the photon-counting detector may be postprocessed. For example, insulating resins (e.g., an adhesive) may be filled between the surface of the chip that has the one or more saddle-backings and the surface of the sensor layer with the one or more conductive points, thereby improving a strength of the connection between the sensor layer and the chip.

Merely by way of example, a process for preparing a photon-counting detector 1000 may be taken as an example. Referring to FIG. 10, FIG. 10 is a schematic diagram illustrating an exemplary photon-counting detector 1000 according to some embodiments of the present disclosure. To prepare the photon-counting detector 1000, a chip 1010 may be firstly connected with a substrate 1020 via a flip-chip bonding interconnection. The chip 1010 may include a plurality of through-silicon vias (TSVs) 1040 for an electrical connection. In some embodiments, spaces between weld metal dots 1050 may be filled with an adhesive, thereby improving a strength of the connection between the substrate 1020 and the chip 1010. Then, a plurality of saddle-backings 1060 may be formed on a surface of the chip 1010 that is opposite to another surface that connects the substrate 1020 via a wire bonding interconnection. A plurality of conductive points 1070 on a surface of a sensor layer 1030 via the flip-chip bonding interconnection or the wire-bonding interconnection. Further, the surface of the chip 1010 that has the plurality of saddle-backings 1060 may be connected with the surface of the sensor layer 1030 with the plurality of conductive points 1070 via the flip-chip bonding interconnection. For example, each of the plurality of saddle-backings 1060 may be connected with one of the plurality of conductive points 1070 via the flip-chip bonding interconnection. In some embodiments, the photon-counting detector 1000 may be postprocessed. For example, spaces between the chip 1010 and the sensor layer 1030 (e.g., spaces between the plurality of saddle-backings 1060 and the plurality of conductive points 1070) may be filled with insulating resins (e.g., the adhesive).

Comparing to a conventional photon-counting detector, the photon-counting detector (e.g., the photon-counting detector 1000) may be simplified by omitting a substrate between the sensor layer and the chip. Therefore, a thickness of the photon-counting detector may be reduced, which reduces an alignment length, further reducing power consumption and/or improving the reliability and stability of the photon-counting detector. Correspondingly, the process for obtaining the photon-counting detector may be simplified, which reduces the difficulty of the package and reduces the cost of the package.

FIG. 11 is a flowchart illustrating an exemplary process 1100 for preparing a photon-counting detector according to some embodiments of the present disclosure. The operations of the illustrated process presented below are intended to be illustrative. In some embodiments, the process 1100 may be accomplished with one or more additional operations not described, and/or without one or more of the operations discussed. Additionally, the order in which the operations of the process 1100 as illustrated in FIG. 11 and described below is not intended to be limiting.

In 1102, a chip may be connected with a substrate.

In some embodiments, the chip may be connected with the substrate in a similar manner as described in operation 902, which is not repeated herein.

In 1104, a redistribution layer may be formed on a surface of the chip that is opposite to another surface that connects the substrate. However, this step does not form part of the claimed invention.

The redistribution layer may refer to a layer with multi-layer interconnection and flat expansion. In some embodiments, the redistribution layer may be formed on a surface of the chip that is opposite to another surface that connects the substrate. Therefore, a surface of the redistribution layer may be electrically connected with the chip, and another surface of the redistribution layer may be electrically connected with the sensor layer.

In some embodiments, the redistribution layer may be formed through a deposition operation. For example, the surface of the chip that is opposite to another surface that connects the substrate may be deposited with a seed layer, a photolithography layer, a plating layer, a dielectric layer, or the like, or any combination thereof.

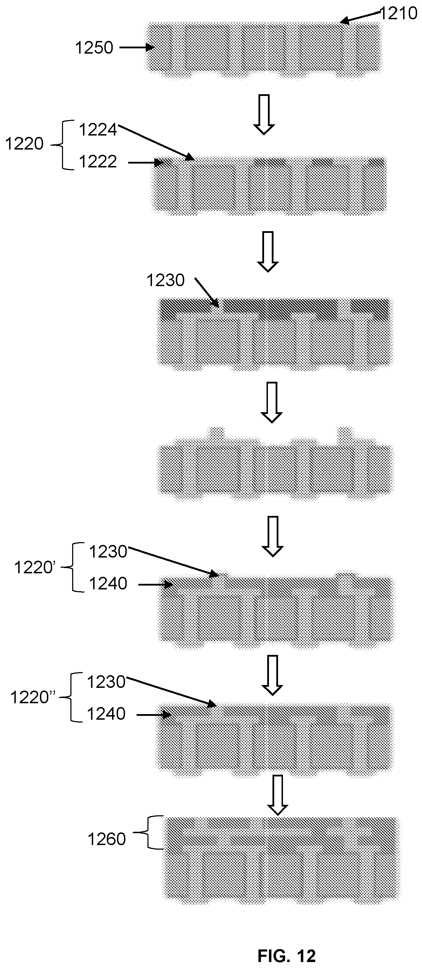

Merely by way of example, referring to FIG. 12, FIG. 12 is a schematic diagram illustrating an exemplary process for forming a redistribution layer according to some embodiments of the present disclosure, not forming part of the invention. As shown in FIG. 12, a seed layer 1210 may be deposited on a surface of a chip 1250 for subsequent plating. A photolithography layer 1222 and a plating layer 1224 may be deposited on the seed layer 1210 to form a preliminary first layer 1220 of a redistribution layer 1260. In some embodiments, the seed layer 1210 may include a conductive metal material the same as the plating layer 1224. For example, the seed layer 1210 may include a copper (Cu) layer, and the plating layer 1224 may also include a Cu plating layer. The photolithography layer 1222 and the plating layer 1224 may be further deposited to form connecting pillars 1230. And then, the photolithography layer 1222 may be removed by etching. A dielectric layer 1240 (e.g., polyimide (PI) or a proposed composite) may be coated (e.g., spin-coated) and cured on the plating layer 1224 to form an intermediate first layer 1220'. Since the connecting pillars 1230 are coated by the dielectric layer 1240, the dielectric layer 1240 may be polished to reveal the connecting pillars 1230. Therefore, a target first layer 1220" may be formed. In some embodiments, a thickness of the target first layer 1220" may be within a preset thickness threshold. The preset thickness threshold may be determined based on an actual requirement (e.g., an efficiency requirement, an assembling requirement, etc.). Similarly, the redistribution layer 1260 may be formed by depositing a plurality of layers.

In 1106, the redistribution layer may be connected with the sensor layer.

For example, the redistribution layer may be electrically connected with the sensor layer through an adhesive.

FIG. 13 is a flowchart illustrating an exemplary process 1300 for preparing a photon-counting detector according to some embodiments of the present disclosure. The operations of the illustrated process presented below are intended to be illustrative. In some embodiments, the process 1300 may be accomplished with one or more additional operations not described, and/or without one or more of the operations discussed. Additionally, the order in which the operations of the process 1300 as illustrated in FIG. 13 and described below is not intended to be limiting.

In 1302, a chip may be connected with a substrate.

In some embodiments, the chip may be connected with the substrate in a similar manner as described in operation 902, which is not repeated herein.

In 1304, a silicon interposer including a plurality of TSVs may be connected with a surface of the chip that is opposite to another surface that connects the substrate.

The silicon interposer may refer to an interposer made of silicon that defines a plurality of TSVs. Each of the plurality of TSVs may be substantially parallel to a reference direction, and the reference direction may be substantially perpendicular to a surface of the sensor layer that receives incident radiation photons.

In some embodiments, the silicon interposer may be formed through a Bosch process. More descriptions regarding the Bosch process may be found elsewhere in the present disclosure (e.g., FIG. 4 and the descriptions thereof).

In some embodiments, the silicon interposer may be formed through a two-stage process. Merely by way of example, referring to FIG. 14, FIG. 14 is a schematic diagram illustrating an exemplary process for forming a silicon interposer according to some embodiments of the present disclosure. As shown in FIG. 14, a first hole 1402 may be etched from a first side of a silicon wafer 1410, and a second hole 1404 may be etched from a second side of the silicon wafer 1410. In some embodiments, a diameter of the first hole 1402 may be the same as or different from a diameter of the second hole 1404. For example, as shown in FIG. 14, the diameter of the first hole 1402 may be larger than the diameter of the second hole 1404. The first hole 1402 may be connected with the second hole 1404. That is, the first hole 1402 and the second hole 1404 may form a TSV. After the TSV is formed, a surface of the TSV may be deposited with a plurality of layers 1406. For example, an oxidation layer, a sputtering layer (e.g., a Ti/Cu layer), a plating layer (e.g., a Cu layer), or the like, or any combination thereof, may be deposited on the surface of the TSV. And then, the surface of the TSV may be further etched according to a wet-etching process. Further, a nickel-gold layer may be plated on the etched surface of the TSV.

In 1306, the sensor layer may be connected with a surface of the silicon interposer that is opposite to another surface that connects the chip.

For example, the sensor layer may be electrically connected with the silicon interposer through an adhesive.

Comparing to a conventional photon-counting detector, the chip and the sensor layer may be electrically connected through the silicon interposer. Accordingly, positive electrodes of the sensor layer and connection components of the chip may be electrically connected through the redistribution layer or the silicon interposer, which can reduce the line width and the line spacing of the photon-counting detector, thereby realizing a high-density connection. In addition, by using the redistribution layer or the silicon interposer, a thickness of the photon-counting detector may be reduced, which reduces an alignment length, further improving the reliability and stability of the photon-counting detector.

It should be noted that the above description is merely provided for the purposes of illustration, and not intended to limit the scope of the present disclosure. For persons having ordinary skills in the art, multiple variations and modifications may be made under the teachings of the present disclosure. However, those variations and modifications do not depart from the scope of the present disclosure. For example, the sensor layer may be connected with the chip before the substrate is connected with the chip.

Having thus described the basic concepts, it may be rather apparent to those skilled in the art after reading this detailed disclosure that the foregoing detailed disclosure is intended to be presented by way of example only and is not limiting. Various alterations, improvements, and modifications may occur and are intended for those skilled in the art, though not expressly stated herein. These alterations, improvements, and modifications are intended to be suggested by this disclosure, and are within scope of the appended claims.

In some embodiments, the numbers expressing quantities or properties used to describe and claim certain embodiments of the application are to be understood as being modified in some instances by the term "about," "approximate," or "substantially." For example, "about," "approximate," or "substantially" may indicate ±20% variation of the value it describes, unless otherwise stated. Accordingly, in some embodiments, the numerical parameters set forth in the written description and attached claims are approximations that may vary depending upon the desired properties sought to be obtained by a particular embodiment. In some embodiments, the numerical parameters should be construed in light of the number of reported significant digits and by applying ordinary rounding techniques. Notwithstanding that the numerical ranges and parameters setting forth the broad scope of some embodiments of the application are approximations, the numerical values set forth in the specific examples are reported as precisely as practicable.

## Claims

1. A photo-counting detector (200), comprising:
a sensor layer (201) configured to detect incident radiation photons and generate electrical signals;
a chip (202) electrically connected with the sensor layer (201), the chip including a plurality of connection components through the chip (202) and one or more processing circuits (304), wherein each of the one or more processing circuits (304) are electrically connected with one or more parts of the sensor layer (201) through at least one of the plurality of connection components; and
a substrate (203) electrically connected with the chip (202); wherein
the chip (202) defines a through-silicon via, TSV, (301) and at least partial of the plurality of connection components are arranged within the TSV (301), the TSV (301) being substantially parallel to a reference direction, and the reference direction being substantially perpendicular to a surface of the sensor layer (201) that receives the incident radiation photons; wherein
the TSV (301) passes through the chip (202) along the reference direction and forms a first opening on a first surface of the chip (202) that is connected with the sensor layer (201) and a second opening on a second surface of the chip (202) that is connected with the substrate (203),
the photo-counting detector being **characterized in that** the chip (202) is electrically connected with the sensor layer (201) through a silicon interposer including a plurality of TSVs.

2. The photo-counting detector (200) of claim 1, wherein the substrate (203) is further configured for power supply for the chip (202).

3. The photo-counting detector (200) of claim 1, wherein the one or more processing circuits (304) are located on the second surface of the chip (202).

4. The photo-counting detector (200) of claim 1, wherein a diameter of the first opening is substantially equal to a diameter of the second opening.

5. The photon-counting detector (200) of claim 4, wherein the TSV (301) includes a depth along the reference direction, a ratio of the depth to the diameter of the first opening or the diameter of the second opening being greater or equal to 1.6.

6. The photo-counting detector (200) of any one of claims 3-5, wherein the one or more processing circuits (304) are located on the first surface of the chip (202), and each of the plurality of TSVs (301) is formed by etching from the second surface of the chip (202) to the first surface of the chip (202); or
the one or more processing circuits (304) are located on the second surface of the chip (202), and each of the plurality of TSVs (301) is formed by etching from the first surface of the chip (202) to the second surface of the chip (202).

7. The photon-counting detector (200) of any one of claims 3-6, wherein one of the plurality of TSVs (301) is deposited by at least one of an insulation layer, a barrier layer, a seed layer, or a plating layer, wherein
the insulation layer includes a silicon dioxide (SiO2) layer that is deposited via plasma enhanced chemical vapor deposition (PECVD), the barrier layer including a titanium (Ti) layer that is deposited via physical vapor deposition (PVD),
the seed layer includes a conductive metal material the same as the plating layer, and the seed layer is deposited via physical vapor deposition (PVD).

8. The photo-counting detector (200) of any one of claims 1-7, wherein the chip (202) is made of a wafer, and the plurality of TSVs (301) are formed in the chip (202) by thinning the wafer.

9. The photo-counting detector (200) of any one of claims 1-8, wherein the at least one of the plurality of processing circuits (304) is configured to receive, through a TSV (301) that is connected with the processing circuit (304), a portion of the electrical signals for determining information of the incident radiation photon.

10. The photo-counting detector of any one of claims 1-9, wherein the substrate (203) is configured to receive a second electrical signal including the information of the incident radiation photons from the chip (202) for outputting.

11. The photo-counting detector of any one of claims 1, wherein the sensor layer is (201) electrically connected with a surface of the silicon interposer that is opposite to another surface that connects the chip.

12. A method for preparing a photo-counting detector (200), the photon-counting detector (200) comprising:
a sensor layer (201) configured to detect incident radiation photons and generate electrical signals;
a chip (202) electrically connected with the sensor layer (201), the chip including a plurality of connection components through the chip (202) and one or more processing circuits (304), wherein each of the one or more processing circuits (304) are electrically connected with one or more parts of the sensor layer (201) through at least one of the plurality of connection components; and
a substrate (203) electrically connected with the chip (202); wherein
the chip (202) defines a through-silicon via, TSV, (301) and at least partial of the plurality of connection components are arranged within the TSV (301), the TSV (301) being substantially parallel to a reference direction, and the reference direction being substantially perpendicular to a surface of the sensor layer (201) that receives the incident radiation photons; wherein
the TSV (301) passes through the chip (202) along the reference direction and forms a first opening on a first surface of the chip (202) that is connected with the sensor layer (201) and a second opening on a second surface of the chip (202) that is connected with the substrate (203),
**characterized in that** the chip (202) is electrically connected with the sensor layer (201) through a silicon interposer including a plurality of TSVs.

13. The method of claim 12, wherein the chip (202) is obtained through a process, the process including:
providing a wafer including the one or more processing circuits (304) located on a first surface of the wafer;
thinning the wafer from a second surface of the wafer, a thickness of the thinned wafer being equal to or greater than 200 microns;
preparing the plurality of connection components in the thinned wafer from the second surface to the first surface;
obtaining the chip (202) by electrically connecting the wafer with the one or more processing circuits (304); and
connecting the chip (202) with the sensor layer (201) and the substrate (201).

## Patentansprüche

1. Photonenzähldetektor (200), umfassend:
eine Sensorschicht (201), die konfiguriert ist, um einfallende Strahlungsphotonen zu detektieren und elektrische Signale zu erzeugen;
einen Chip (202), der elektrisch mit der Sensorschicht (201) verbunden ist, wobei der Chip eine Vielzahl von
Verbindungskomponenten über den Chip (202) und eine oder mehrere Verarbeitungsschaltungen (304) beinhaltet, wobei jede der einen oder mehreren Verarbeitungsschaltungen (304) über mindestens eine der Vielzahl von Verbindungskomponenten elektrisch mit einem oder mehreren Teilen der Sensorschicht (201) verbunden ist; und
ein Substrat (203), das elektrisch mit dem Chip (202) verbunden ist; wobei
der Chip (202) eine Silizium-Durchkontaktierung TSV (301) definiert und mindestens ein Teil der Vielzahl von Verbindungskomponenten ist innerhalb der TSV (301) angeordnet sind, wobei die TSV (301) im Wesentlichen parallel zu einer Referenzrichtung verläuft und die Referenzrichtung im Wesentlichen senkrecht zu einer Oberfläche der Sensorschicht (201) steht, welche die einfallenden Strahlungsphotonen empfängt; wobei
die TSV (301) entlang der Referenzrichtung durch den Chip (202) verläuft und eine erste Öffnung auf einer ersten Oberfläche des Chips (202) bildet, die mit der Sensorschicht (201) verbunden ist, und eine zweite Öffnung auf einer zweiten Oberfläche des Chips (202), die mit dem Substrat (203) verbunden ist,
wobei der Photonenzähldetektor **dadurch gekennzeichnet ist, dass** der Chip (202) über ein Silizium-Zwischenelement, das mehrere TSVs beinhaltet, elektrisch mit der Sensorschicht (201) verbunden ist.

2. Photonenzähldetektor (200) nach Anspruch 1, wobei das Substrat (203) weiter zur Leistungsversorgung des Chips (202) konfiguriert ist.

3. Photonenzähldetektor (200) nach Anspruch 1, wobei sich die eine oder mehrere Verarbeitungsschaltungen (304) auf der zweiten Oberfläche des Chips (202) befinden.

4. Photonenzähldetektor (200) nach Anspruch 1, wobei ein Durchmesser der ersten Öffnung im Wesentlichen gleich dem Durchmesser der zweiten Öffnung ist.

5. Photonenzähldetektor (200) nach Anspruch 4, wobei die TSV (301) eine Tiefe entlang der Referenzrichtung beinhaltet, wobei ein Verhältnis der Tiefe zum Durchmesser der ersten Öffnung oder zum Durchmesser der zweiten Öffnung größer oder gleich 1,6 ist.

6. Photonenzähldetektor (200) nach einem der Ansprüche 3-5, wobei sich die eine oder mehrere Verarbeitungsschaltungen (304) auf der ersten Oberfläche des Chips (202) befinden und jede der Vielzahl von TSVs (301) durch Ätzen von der zweiten Oberfläche des Chips (202) zur ersten Oberfläche des Chips (202) gebildet wird; oder
sich die eine oder mehrere Verarbeitungsschaltungen (304) auf der zweiten Oberfläche des Chips (202) befinden und jede der Vielzahl von TSVs (301) durch Ätzen von der ersten Oberfläche des Chips (202) zur zweiten Oberfläche des Chips (202) gebildet wird.

7. Photonenzähldetektor (200) nach einem der Ansprüche 3-6, wobei eine der Vielzahl von TSVs (301) durch mindestens eine Isolierschicht, eine Barriereschicht, eine Keimschicht oder eine Plattierungsschicht abgeschieden ist, wobei
die Isolierschicht eine Siliziumdioxid-, (Si02)-Schicht beinhaltet, die mittels plasmaverstärkter chemischer Gasphasenabscheidung (PECVD) abgeschieden wird, die Barriereschicht eine Titan-, (Ti)-Schicht beinhaltet, die mittels physikalischer Gasphasenabscheidung (PVD) abgeschieden wird.
die Keimschicht ein leitfähiges Metallmaterial beinhaltet, das gleich wie die Plattierungsschicht ist, und die Keimschicht mittels physikalischer Dampfabscheidung (PVD) abgeschieden wird.

8. Photonenzähldetektor (200) nach einem der Ansprüche 1-7, wobei der Chip (202) aus einem Wafer gefertigt ist, und die Vielzahl von TSVs (301) durch Ausdünnen des Wafers im Chip (202) gebildet sind.

9. Photonenzähldetektor (200) nach einem der Ansprüche 1-8, wobei die mindestens eine der Vielzahl von Verarbeitungsschaltungen (304) konfiguriert ist, um über eine TSV (301), die mit der Verarbeitungsschaltung (304) verbunden ist, einen Abschnitt der elektrischen Signale zum Bestimmen von Informationen über das einfallende Strahlungsphoton zu empfangen.

10. Photonenzähldetektor nach einem der Ansprüche 1-9, wobei das Substrat (203) konfiguriert ist, um vom Chip (202) ein zweites elektrisches Signal zum Ausgeben zu empfangen, das die Information über die einfallenden Strahlungsphotonen beinhaltet.

11. Photonenzähldetektor nach einem der Ansprüche 1, wobei die Sensorschicht (201) elektrisch mit einer Oberfläche des Silizium-Zwischenelements, die einer anderen Oberfläche gegenüberliegt, die den Chip verbindet, verbunden ist.

12. Verfahren zur Herstellung eines Photonenzähldetektors (200), wobei der Photonenzähldetektor (200) umfasst:
eine Sensorschicht (201), die konfiguriert ist, um einfallende Strahlungsphotonen zu detektieren und elektrische Signale zu erzeugen;
einen Chip (202), der elektrisch mit der Sensorschicht (201) verbunden ist, wobei der Chip eine Vielzahl von Verbindungskomponenten über den Chip (202) und eine oder mehrere Verarbeitungsschaltungen (304) beinhaltet, wobei jede der einen oder mehreren Verarbeitungsschaltungen (304) über mindestens eine der Vielzahl von Verbindungskomponenten elektrisch mit einem oder mehreren Teilen der Sensorschicht (201) verbunden ist; und
ein Substrat (203), das elektrisch mit dem Chip (202) verbunden ist; wobei
der Chip (202) eine Silizium-Durchkontaktierung, TSV, (301) definiert und mindestens ein Teil der Vielzahl von Verbindungskomponenten ist innerhalb der TSV (301) angeordnet sind, wobei die TSV (301) im Wesentlichen parallel zu einer Referenzrichtung verläuft und die Referenzrichtung im Wesentlichen senkrecht zu einer Oberfläche der Sensorschicht (201) steht, welche die einfallenden Strahlungsphotonen empfängt; wobei
die TSV (301) entlang der Referenzrichtung durch den Chip (202) verläuft und eine erste Öffnung auf einer ersten Oberfläche des Chips (202) bildet, die mit der Sensorschicht (201) verbunden ist, und eine zweite Öffnung auf einer zweiten Oberfläche des Chips (202), die mit dem Substrat (203) verbunden ist,
**dadurch gekennzeichnet, dass** der Chip (202) über ein Silizium-Zwischenelement, das mehrere TSVs beinhaltet, elektrisch mit der Sensorschicht (201) verbunden ist.

13. Verfahren nach Anspruch 12, wobei der Chip (202) durch einen Prozess erhalten wird, wobei der Prozess beinhaltet:
Bereitstellen eines Wafers, der die einen oder mehreren auf einer ersten Oberfläche des Wafers befindliche Verarbeitungsschaltungen (304) beinhaltet;
Ausdünnen des Wafers von einer zweiten Oberfläche des Wafers aus, wobei eine Dicke des ausgedünnten Wafers größer oder gleich 200 Mikrometer ist;
Vorbereiten der Vielzahl von Verbindungskomponenten im ausgedünnten Wafer von der zweiten Oberfläche zur ersten Oberfläche;
Erhalten des Chips (202) durch elektrisches Verbinden des Wafers mit der einen oder mehreren Verarbeitungsschaltungen (304); und
Verbinden des Chips (202) mit der Sensorschicht (201) und dem Substrat (201).

## Revendications

1. Détecteur de comptage de photons (200), comprenant :
une couche de capteur (201) configurée pour détecter des photons de rayonnement incident et générer des signaux électriques ;
une puce (202) connectée électriquement à la couche de capteurs (201), la puce incluant une pluralité de
composants de connexion à travers la puce (202) et un ou plusieurs circuits de traitement (304), dans lequel chacun des un ou plusieurs circuits de traitement (304) est connecté électriquement à une ou plusieurs parties de la couche de capteur (201) par l'intermédiaire d'au moins un de la pluralité de composants de connexion ; et
un substrat (203) connecté électriquement à la puce (202) ; dans lequel
la puce (202) définit un trou d'interconnexion traversant le silicium, TSV, (301), et au moins une partie de la pluralité de composants de connexion sont disposés à l'intérieur du TSV (301), le TSV (301) étant sensiblement parallèle à une direction de référence, et la direction de référence étant sensiblement perpendiculaire à une surface de la couche de capteur (201) qui reçoit les photons de rayonnement incident ; dans lequel
le TSV (301) traverse la puce (202) suivant la direction de référence et forme une première ouverture sur une première surface de la puce (202) qui est connectée à la couche de capteur (201) et une seconde ouverture sur une seconde surface de la puce (202) qui est connectée au substrat (203),
le détecteur de comptage de photons étant **caractérisé en ce que** la puce (202) est connectée électriquement à la couche de capteur (201) par l'intermédiaire d'un interposeur en silicium incluant une pluralité de TSV.

2. Détecteur de comptage de photons (200) selon la revendication 1, dans lequel le substrat (203) est en outre configuré pour l'alimentation électrique de la puce (202).

3. Détecteur de comptage de photons (200) selon la revendication 1, dans lequel les un ou plusieurs circuits de traitement (304) sont situés sur la seconde surface de la puce (202).

4. Détecteur de comptage de photons (200) selon la revendication 1, dans lequel un diamètre de la première ouverture est sensiblement égal à un diamètre de la seconde ouverture.

5. Détecteur de comptage de photons (200) selon la revendication 4, dans lequel le TSV (301) inclut une profondeur suivant la direction de référence, un rapport de la profondeur au diamètre de la première ouverture ou au diamètre de la seconde ouverture étant supérieur ou égal à 1,6.

6. Détecteur de comptage de photons (200) selon l'une quelconque des revendications 3-5, dans lequel les un ou plusieurs circuits de traitement (304) sont situés sur la première surface de la puce (202), et chacun de la pluralité de TSV (301) est formé par gravure de la seconde surface de la puce (202) vers la première surface de la puce (202) ; ou
les un ou plusieurs circuits de traitement (304) sont situés sur la seconde surface de la puce (202), et chacun de la pluralité de TSV (301) est formé par gravure de la première surface de la puce (202) à la seconde surface de la puce (202).

7. Détecteur de comptage de photons (200) selon l'une quelconque des revendications 3-6, dans lequel un de la pluralité de TSV (301) est déposé par au moins une parmi une couche d'isolation, une couche barrière, une couche d'amorçage ou une couche de placage, dans lequel
la couche d'isolation inclut une couche de dioxyde de silicium (SiO2) qui est déposée par dépôt chimique en phase vapeur assisté par plasma (PECVD), la couche barrière incluant une couche de titane (Ti) qui est déposée par dépôt physique en phase vapeur (PVD),
la couche d'amorçage inclut un matériau métallique conducteur identique à la couche de placage, et la couche d'amorçage est déposée par dépôt physique en phase vapeur (PVD).

8. Détecteur de comptage de photons (200) selon l'une quelconque des revendications 1-7, dans lequel la puce (202) est constituée d'une plaquette, et la pluralité de TSV (301) sont formés dans la puce (202) en amincissant la plaquette.

9. Détecteur de comptage de photons (200) selon l'une quelconque des revendications 1-8, dans lequel l'au moins un de la pluralité de circuits de traitement (304) est configuré pour recevoir, par l'intermédiaire d'un TSV (301) qui est connecté au circuit de traitement (304), une partie des signaux électriques pour déterminer des informations du photon de rayonnement incident.

10. Détecteur de comptage de photons selon l'une quelconque des revendications 1-9, dans lequel le substrat (203) est configuré pour recevoir un second signal électrique incluant les informations des photons de rayonnement incident provenant de la puce (202) pour la délivrance en sortie.

11. Détecteur de comptage de photons selon l'une quelconque des revendications 1, dans lequel la couche de capteur (201) est connectée électriquement à une surface de l'interposeur en silicium qui est opposée à une autre surface qui connecte la puce.

12. Procédé de préparation d'un détecteur de comptage de photons (200), le détecteur de comptage de photons (200) comprenant :
une couche de capteur (201) configurée pour détecter des photons de rayonnement incident et générer des signaux électriques ;
une puce (202) connectée électriquement à la couche de capteur (201), la puce incluant une pluralité de composants de connexion à travers la puce (202) et un ou plusieurs circuits de traitement (304), dans lequel chacun des un ou plusieurs circuits de traitement (304) est connecté électriquement à une ou plusieurs parties de la couche de capteur (201) par l'intermédiaire d'au moins un de la pluralité de composants de connexion ; et
un substrat (203) connecté électriquement à la puce (202) ; dans lequel
la puce (202) définit un trou d'interconnexion traversant le silicium, TSV, (301), et au moins une partie de la pluralité de composants de connexion sont disposés à l'intérieur du TSV (301), le TSV (301) étant sensiblement parallèle à une direction de référence, et la direction de référence étant sensiblement perpendiculaire à une surface de la couche de capteur (201) qui reçoit les photons de rayonnement incident ; dans lequel
le TSV (301) traverse la puce (202) suivant la direction de référence et forme une première ouverture sur une première surface de la puce (202) qui est connectée à la couche de capteur (201) et une seconde ouverture sur une seconde surface de la puce (202) qui est connectée au substrat (203),
**caractérisé en ce que** la puce (202) est connectée électriquement à la couche de capteur (201) par l'intermédiaire d'un interposeur en silicium incluant une pluralité de TSV.

13. Procédé selon la revendication 12, dans lequel la puce (202) est obtenue par un processus, le processus incluant :
la fourniture d'une plaquette incluant les un ou plusieurs circuits de traitement (304) situés sur une première surface de la plaquette ;
l'amincissement de la plaquette à partir d'une seconde surface de la plaquette, une épaisseur de la plaquette amincie étant égale ou supérieure à 200 microns ;
la préparation de la pluralité de composants de connexion dans la plaquette amincie, de la seconde surface à la première surface ;
l'obtention de la puce (202) en connectant électriquement la plaquette aux un ou plusieurs circuits de traitement (304) ; et
la connexion de la puce (202) avec la couche de capteur (201) et le substrat (201).
